# EUROPEAN PATENT SPECIFICATION

(11) **EP 4 652 601 B1**
(45) Date of publication and mention of the grant of the patent: **05.08.2026**
(21) Application number: 23844073.9
(22) Date of filing: 28.11.2023
(51) Int. Cl.: G11C 16/34, G11C 16/04, G11C 16/08, G11C 11/56, G11C 16/10, G11C 16/32

(54) **MEMORY DEVICE AND PROGRAM OPERATION THEREOF**
SPEICHERVORRICHTUNG UND PROGRAMMBETRIEB DAFÜR
DISPOSITIF DE MÉMOIRE ET OPÉRATION DE PROGRAMME ASSOCIÉE

(43) Date of publication of application: 26.11.2025
(60) Divisional application: 26187874.8
(73) Proprietor: Yangtze Memory Technologies Co., Ltd., Wuhan, Hubei 430000 (CN)
(72) Inventor: MIN, Yuanyuan, Wuhan, Hubei 430000 (CN); YOU, Kaikai, Wuhan, Hubei 430000 (CN); CUI, Ying, Wuhan, Hubei 430000 (CN); JIA, Jianquan, Wuhan, Hubei 430000 (CN); ZHAO, Xiangnan, Wuhan, Hubei 430000 (CN)
(74) Representative: Lippert Stachow Patentanwälte Rechtsanwälte
(86) International application number: PCT/CN2023/134561
(87) International publication number: WO 2025/111772

(56) References cited:
- US-A1- 2019 318 784
- US-A1- 2022 130 474
- US-A1- 2022 189 566
- US-A1- 2023 132 781
- US-A1- 2023 145 467

## Description

### BACKGROUND

The present disclosure relates to memory devices and operation methods thereof.

Flash memory is a low-cost, high-density, non-volatile solid-state storage medium that can be electrically erased and reprogrammed. Flash memory includes NOR Flash memory and NAND Flash memory. Various operations can be performed by Flash memory, such as read, program (write), and erase. For NAND Flash memory, an erase operation can be performed at the block level, and a program operation or a read operation can be performed at the page level. A known nonvolatile memory device is disclosed in US 2022/0130474 A1 comprising at least one memory block and a control circuit, wherein the at least one memory block includes a plurality of cell strings, each including a string selection transistor, a plurality of memory cells and a ground. US 2022/0189566 A1 relates to a method for reading a memory device including a first memory cell string, in a pre-verify stage, a first verify voltage is applied on a gate terminal of a selected memory cell of the first memory cell string, where the selected memory cell is programmed and arranged between a first adjacent memory cell and a second adjacent memory cell. US 2023/0132781 Al discloses memory device includes memory strings each including a drain select gate transistor; and memory cells, and a peripheral circuit coupled to the memory strings.

### SUMMARY

In one aspect, a memory device includes the features recited in claim 1.

In some implementations, the program operation is an incremental step pulse program (ISPP), and the first loop and the second loop are a starting loop and an ending loop of the ISPP, respectively.

In some implementations, the word line driver is further configured to in the pre-pulse period and the post-pulse period in the first loop of the program operation, turn off the SSG transistor in the unselect memory string, and in the at least one of the pre-pulse period or the post-pulse period in the second loop of the program operation, turn on the SSG transistor in the unselect memory string.

In some implementations, the word line driver is further configured to in a verify period between the pre-pulse period and the post-pulse period in the first loop of the program operation, turn off the DSG transistor and the SSG transistor in the unselect memory string, and in a verify period between the pre-pulse period and the post-pulse period in the second loop of the program operation, turn off the DSG transistor and the SSG transistor in the unselect memory string.

In some implementations, the word line driver is further configured to in the pre-pulse period in the second loop of the program operation, turn off the DSG transistor and the SSG transistor in the unselect memory string, and in the post-pulse period in the second loop of the program operation, turn on the DSG transistor and the SSG transistor in the unselect memory string.

In some implementations, the word line driver is further configured to in the pre-pulse period in the second loop of the program operation, turn on the DSG transistor and the SSG transistor in the unselect memory string, and in the post-pulse period in the second loop of the program operation, turn off the DSG transistor and the SSG transistor in the unselect memory string.

In some implementations, the DSG transistor in the select memory string is electrically separated from the DSG transistor in the unselect memory string.

In another aspect, a method for operating a memory device is provided comprising the features recited in claim 8.

In some implementations, the program operation is an ISPP, and the first loop and the second loop are a starting loop and an ending loop of the ISPP, respectively.

In some implementations, in the pre-pulse period and the post-pulse period in the first loop of the program operation, the SSG transistor in the unselect memory string is turned off, and in the at least one of the pre-pulse period or the post-pulse period in the second loop of the program operation, the SSG transistor in the unselect memory string is turned on.

In some implementations, in a verify period between the pre-pulse period and the post-pulse period in the first loop of the program operation, the DSG transistor and the SSG transistor in the unselect memory string are turned off, and in a verify period between the pre-pulse period and the post-pulse period in the second loop of the program operation, the DSG transistor and the SSG transistor in the unselect memory string is turned off.

In some implementations, in the pre-pulse period in the second loop of the program operation, the DSG transistor and the SSG transistor in the unselect memory string are turned off, and in the post-pulse period in the second loop of the program operation, the DSG transistor and the SSG transistor in the unselect memory string is turned on.

In some implementations, in the pre-pulse period in the second loop of the program operation, the DSG transistor and the SSG transistor in the unselect memory string are turned on, and in the post-pulse period in the second loop of the program operation, the DSG transistor and the SSG transistor in the unselect memory string is turned off.

In some implementations, the DSG transistor in a select memory string is electrically separated from the DSG transistor in the unselect memory string.

In still another aspect, a system includes a memory device configured to store data, and a memory controller coupled to the memory device and configured to control the memory device. The memory device includes memory strings each including a DSG transistor, memory cells, and an SSG transistor, and a peripheral circuit coupled to the memory strings. The peripheral circuit is configured to, in a program operation, program a select memory cell of the memory cells in a select memory string of the memory strings, and inhibit an unselect memory cell of the memory cells in an unselect memory string of the memory strings. The peripheral circuit includes a word line driver configured to in a pre-pulse period and a post-pulse period in a first loop of the program operation, turn off the DSG transistor in the unselect memory string, and in at least one of a pre-pulse period or a post-pulse period in a second loop of the program operation after the first loop, turn on the DSG transistor in the unselect memory string.

In some implementations, the program operation is an ISPP, and the first loop and the second loop are a starting loop and an ending loop of the ISPP, respectively.

In some implementations, the word line driver is further configured to in the pre-pulse period and the post-pulse period in the first loop of the program operation, turn off the SSG transistor in the unselect memory string, and in the at least one of the pre-pulse period or the post-pulse period in the second loop of the program operation, turn on the SSG transistor in the unselect memory string.

In some implementations, the word line driver is further configured to in a verify period between the pre-pulse period and the post-pulse period in the first loop of the program operation, turn off the DSG transistor and the SSG transistor in the unselect memory string, and in a verify period between the pre-pulse period and the post-pulse period in the second loop of the program operation, turn off the DSG transistor and the SSG transistor in the unselect memory string.

In some implementations, the word line driver is further configured to in the pre-pulse period in the second loop of the program operation, turn off the DSG transistor and the SSG transistor in the unselect memory string, and in the post-pulse period in the second loop of the program operation, turn on the DSG transistor and the SSG transistor in the unselect memory string.

In some implementations, the word line driver is further configured to in the pre-pulse period in the second loop of the program operation, turn on the DSG transistor and the SSG transistor in the unselect memory string, and in the post-pulse period in the second loop of the program operation, turn off the DSG transistor and the SSG transistor in the unselect memory string.

In some implementations, the DSG transistor in the select memory string is electrically separated from the DSG transistor in the unselect memory string.

In some implementations, the memory device is a NAND Flash memory device.

In yet another aspect, a memory device includes memory strings each including a DSG transistor, memory cells, and an SSG transistor, and a peripheral circuit coupled to the memory strings. The peripheral circuit is configured to, in a program operation, program a select memory cell of the memory cells in a select memory string of the memory strings, and inhibit an unselect memory cell of the memory cells in an unselect memory string of the memory strings. The peripheral circuit includes a word line driver configured to in only one of a pre-pulse period or a post-pulse period in a first loop of the program operation, turn on the DSG transistor in the unselect memory string, and in only one of a pre-pulse period or a post-pulse period in a second loop of the program operation after the first loop, turn on the DSG transistor in the unselect memory string.

In some implementations, the program operation is an ISPP, and the first loop and the second loop are a starting loop and an ending loop of the ISPP, respectively.

In some implementations, the word line driver is further configured to in the only one of the pre-pulse period or the post-pulse period in the first loop of the program operation, turn on the SSG transistor in the unselect memory string, and in the only one of the pre-pulse period or the post-pulse period in the second loop of the program operation, turn on the SSG transistor in the unselect memory string.

In some implementations, the word line driver is further configured to in a verify period between the pre-pulse period and the post-pulse period in the first loop of the program operation, turn off the DSG transistor and the SSG transistor in the unselect memory string, and in a verify period between the pre-pulse period and the post-pulse period in the second loop of the program operation, turn off the DSG transistor and the SSG transistor in the unselect memory string.

In some implementations, in the pre-pulse period, but not in the post-pulse period, in the first loop of the program operation, turn on the DSG transistor and the SSG transistor in the unselect memory string, and in the pre-pulse period, but not in the post-pulse period, in the second loop of the program operation, turn on the DSG transistor and the SSG transistor in the unselect memory string.

In some implementations, the word line driver is further configured to in the post-pulse period, but not in the pre-pulse period, in the first loop of the program operation, turn on the DSG transistor and the SSG transistor in the unselect memory string, and in the post-pulse period, but not in the pre-pulse period, in the second loop of the program operation, turn on the DSG transistor and the SSG transistor in the unselect memory string.

In some implementations, the DSG transistor in the select memory string is electrically separated from the DSG transistor in the unselect memory string.

In yet another aspect, a method for operating a memory device is provided. The memory device includes memory strings each including a DSG transistor, memory cells, and an SSG transistor. In only one of a pre-pulse period or a post-pulse period in a first loop of a program operation, the DSG transistor in an unselect memory string of the memory strings is turned on. In only one of a pre-pulse period or a post-pulse period in a second loop of the program operation after the first loop, the DSG transistor in the unselect memory string is turned on.

In some implementations, the program operation is an ISPP, and the first loop and the second loop are a starting loop and an ending loop of the ISPP, respectively.

In some implementations, in the only one of the pre-pulse period or the post-pulse period in the first loop of the program operation, the SSG transistor in the unselect memory string is turned on, and in the only one of the pre-pulse period or the post-pulse period in the second loop of the program operation, the SSG transistor in the unselect memory string is turned on.

In some implementations, in a verify period between the pre-pulse period and the post-pulse period in the first loop of the program operation, the DSG transistor and the SSG transistor in the unselect memory string are turned off, and in a verify period between the pre-pulse period and the post-pulse period in the second loop of the program operation, the DSG transistor and the SSG transistor in the unselect memory string is turned off.

In some implementations, in the pre-pulse period, but not in the post-pulse period, in the first loop of the program operation, the DSG transistor and the SSG transistor in the unselect memory string are turned on, and in the pre-pulse period, but not in the post-pulse period, in the second loop of the program operation, the DSG transistor and the SSG transistor in the unselect memory string is turned on.

In some implementations, in the post-pulse period, but not in the pre-pulse period, in the first loop of the program operation, the DSG transistor and the SSG transistor in the unselect memory string is turned on, and in the post-pulse period, but not in the pre-pulse period, in the second loop of the program operation, the DSG transistor and the SSG transistor in the unselect memory string is turned on.

In some implementations, the DSG transistor in a select memory string is electrically separated from the DSG transistor in the unselect memory string.

In yet another aspect, a system includes a memory device configured to store data, and a memory controller coupled to the memory device and configured to control the memory device. The memory device includes memory strings each including a DSG transistor, memory cells, and an SSG transistor, and a peripheral circuit coupled to the memory strings. The peripheral circuit is configured to, in a program operation, program a select memory cell of the memory cells in a select memory string of the memory strings, and inhibit an unselect memory cell of the memory cells in an unselect memory string of the memory strings. The peripheral circuit includes a word line driver configured to in only one of a pre-pulse period or a post-pulse period in a first loop of the program operation, turn on the DSG transistor in the unselect memory string, and in only one of a pre-pulse period or a post-pulse period in a second loop of the program operation after the first loop, turn on the DSG transistor in the unselect memory string.

In yet another aspect, a memory device includes memory strings each including a DSG transistor, memory cells, and an SSG transistor, and a peripheral circuit coupled to the memory strings. The peripheral circuit is configured to, in a program operation, in a pre-pulse period and a post-pulse period in a first loop of the program operation, apply a select voltage to a first DSG transistor in a first memory string of the memory strings, and apply a deselect voltage to a second DSG transistor in a second memory string of the memory strings. The peripheral circuit is also configured to, in the program operation, in at least one of a pre-pulse period or a post-pulse period in a second loop of the program operation after the first loop, apply the select voltage to the first DSG transistor in the first memory string, and apply the select voltage to the second DSG transistor in the second memory string.

In some implementations, the peripheral circuit is further configured to in a verify period between the pre-pulse period and the post-pulse period in the first loop of the program operation, apply the select voltage to a first SSG transistor in the first memory string, and apply the deselect voltage to a second SSG transistor in the second memory string. In some implementations, the peripheral circuit is further configured to in a verify period between the pre-pulse period and the post-pulse period in the second loop of the program operation, apply the select voltage to the first SSG transistor in the first memory string, and apply the deselect voltage to the second SSG transistor in the second memory string.

In some implementations, the select voltage is a positive voltage, and the deselect voltage is a ground voltage.

In yet another aspect, a memory device includes memory strings each including a DSG transistor, memory cells, and an SSG transistor, and a peripheral circuit coupled to the memory strings. The peripheral circuit is configured to, in a program operation, in a pre-pulse period and a post-pulse period in a first loop of the program operation, apply a select voltage to a first DSG transistor in a first memory string of the memory strings, and in one of the pre-pulse period or the post-pulse period in the first loop of the program operation, apply a deselect voltage to a second DSG transistor in a second memory string of the memory strings. The peripheral circuit is also configured to, in the program operation, in a pre-pulse period and a post-pulse period in a second loop of the program operation after the first loop, apply the select voltage to the first DSG transistor in the first memory string, and in one of the pre-pulse period or the post-pulse period in the second loop of the program operation, apply the deselect voltage to the second DSG transistor in the second memory string.

In some implementations, the peripheral circuit is further configured in a verify period between the pre-pulse period and the post-pulse period in the first loop of the program operation, apply the select voltage to a first SSG transistor in the first memory string, and apply the deselect voltage to a second SSG transistor in the second memory string. In some implementations, the peripheral circuit is further configured to in a verify period between the pre-pulse period and the post-pulse period in the second loop of the program operation, apply the select voltage to the first SSG transistor in the first memory string, and apply the deselect voltage to the second SSG transistor in the second memory string.

In some implementations, the select voltage is a positive voltage, and the deselect voltage is a ground voltage.

### BRIEF DESCRIPTION OF THE DRAWINGS

The accompanying drawings, which are incorporated herein and form a part of the specification, illustrate aspects of the present disclosure and, together with the description, further serve to explain the principles of the present disclosure and to enable a person skilled in the pertinent art to make and use the present disclosure.
FIG. 1 illustrates a schematic diagram of a memory device including peripheral circuits, according to some aspects of the present disclosure.
FIG. 2 illustrates a side view of a cross-section of a memory cell array including a NAND memory string, according to some aspects of the present disclosure.
FIG. 3 illustrates a block diagram of a memory device including a memory cell array and peripheral circuits, according to some aspects of the present disclosure.
FIGs. 4A and 4B illustrate schematic diagrams of three-dimensional (3D) NAND memory strings, according to some aspects of the present disclosure.
FIGs. 5A and 5B illustrate a waveform of word line voltages applied to a select word line in a program operation, according to some aspects of the present disclosure.
FIG. 6 illustrates timing diagrams of a program operation having multiple loops.
FIG. 7 illustrates timing diagrams of a program operation having multiple loops, according to some aspects of the present disclosure.
FIG. 8 illustrates timing diagrams of another program operation having multiple loops, according to some aspects of the present disclosure.
FIG. 9 illustrates timing diagrams of still another program operation having multiple loops, according to some aspects of the present disclosure.
FIG. 10 illustrates timing diagrams of yet another program operation having multiple loops, according to some aspects of the present disclosure.
FIG. 11 illustrates a flowchart of a method for programming a memory device, according to some aspects of the present disclosure.
FIG. 12 illustrates a flowchart of another method for programming a memory device, according to some aspects of the present disclosure.
FIG. 13 illustrates a block diagram of a system having a memory device, according to some aspects of the present disclosure.
FIG. 14A illustrates a diagram of a memory card having a memory device, according to some aspects of the present disclosure.
FIG. 14B illustrates a diagram of a solid-state drive (SSD) having a memory device, according to some aspects of the present disclosure.
FIG. 15 illustrates simulation results of the effect of post-pulse channel cleaning on channel potential, according to some aspects of the present disclosure.

The present disclosure will be described with reference to the accompanying drawings.

### DETAILED DESCRIPTION

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

Memory devices, such as NAND Flash memory devices, can store more than a single bit of information into each memory cell with multiple states in order to increase the storage capacity and reduce the cost per bit. The program operation of a NAND Flash memory device involves a number of program cycles and verify cycles. In order to save program time (t_{PROG}), efforts have been mostly made in the industry on how to reduce the number of verify cycles. On the other hand, for each verify cycle, residual channel potential may remain in the channels of unselect memory strings after the respective program cycle, and hot carrier injection (HCI) effect may occur in the channels of the unselect memory strings by applying the verify voltage pulses(s), both of which can adversely affect the subsequent read operation, e.g., by increasing the failure bit count (FBC). Thus, it is a common practice to turn on the channels of unselect memory strings before and after applying verify voltage pulse(s) in the so-called "pre-pulse period" and "post-pulse period," respectively, in each verify cycle to "clean" the channels. Those operations during the pre-pulse and post-pulse periods, however, prolong the duration of each verify cycle, thereby becoming the bottleneck of saving program time.

To address one or more of the aforementioned issues, the present disclosure provides various "by-loop" channel cleaning schemes that do not clean the channels of unselect memory strings in both the pre-pulse period and post-pulse period in each verify cycle, thereby saving program time. In some implementations, the channel cleaning is skipped in the pre-pulse period and post-pulse period of the verify cycle(s) in the early loop(s), for example, only performed in the pre-pulse period and/or the post-pulse period of the verify cycle in the ending loop (i.e., the last verify cycle). In some implementations, the channel cleaning is performed in only one of the pre-pulse and post-pulse periods, but not both, in each verify cycle. The by-loop channel cleaning schemes disclosed herein can reduce the program time while still mitigating the adverse impacts caused by residual channel potential and the HCI effect.

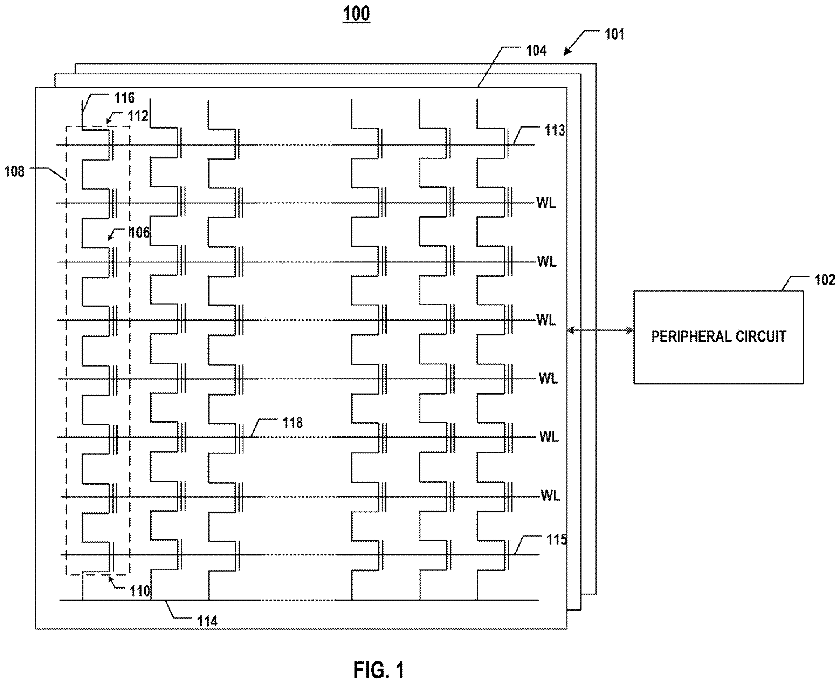

FIG. 1 illustrates a schematic circuit diagram of a memory device 100 including peripheral circuits, according to some aspects of the present disclosure. Memory device 100 can include a memory cell array 101 and peripheral circuits 102 coupled to memory cell array 101. Memory cell array 101 can be a NAND Flash memory cell array in which memory cells 106 are provided in the form of an array of NAND memory strings 108 each extending vertically above a substrate (not shown). In some implementations, each NAND memory string 108 includes a plurality of memory cells 106 coupled in series and stacked vertically. Each memory cell 106 can hold a continuous, analog value, such as an electrical voltage or charge, which depends on the number of electrons trapped within a region of memory cell 106. Each memory cell 106 can be either a floating gate type of memory cell including a floating-gate transistor or a charge trap type of memory cell including a charge-trap transistor.

In some implementations, each memory cell 106 is an SLC that has two possible levels (memory states) and thus, can store one bit of data. For example, the first level "0" can correspond to a first range of threshold voltages, and the second level "1" can correspond to a second range of threshold voltages. In some implementations, each memory cell 106 is an xLC that is capable of storing more than a single bit of data in more than four levels. For example, the xLC may store two bits per cell (MLC), three bits per cell (TLC), or four bits per cell (QLC)). Each xLC can be programmed to assume a range of possible nominal storage values (i.e., corresponding to 2*^{N}* pieces of N-bits data). In some implementations, at least one of memory cells 106 is set to one of 2*^{N}* levels corresponding to a piece of *N*-bits data, where *N* is an integer greater than 1.

As shown in FIG. 1, each NAND memory string 108 can also include a source select gate (SSG) transistor 110 (a.k.a., bottom select gate (BSG) transistor) at its source end and a drain select gate (DSG) transistor 112 (a.k.a., top select gate (TSG) transistor) at its drain end. SSG transistor 110 and DSG transistor 112 can be configured to activate select NAND memory strings 108 (columns of the array) during read and program operations. In some implementations, the sources of NAND memory strings 108 in the same block 104 are coupled through a same source line (SL) 114, e.g., a common SL. In other words, all NAND memory strings 108 in the same block 104 have an array common source (ACS), according to some implementations. The drain of each NAND memory string 108 is coupled to a respective bit line 116 from which data can be read or written via an output bus (not shown), according to some implementations. In some implementations, each NAND memory string 108 is configured to be selected or deselected by applying a select voltage (e.g., a positive voltage greater than the threshold voltage of DSG transistor 112) or a deselect voltage (e.g., the ground voltage) to the gate of respective DSG transistor 112 through one or more DSG lines 113 and/or by applying a select voltage (e.g., a positive voltage greater than the threshold voltage of SSG transistor 110) or a deselect voltage (e.g., the ground voltage) to the gate of respective SSG transistor 110 through one or more SSG lines 115.

As shown in FIG. 1, NAND memory strings 108 can be organized into multiple blocks 104, each of which can have a common source line 114, e.g., coupled to the ACS. In some implementations, each block 104 is the basic data unit for erase operations, i.e., all memory cells 106 on the same block 104 are erased at the same time. To erase memory cells 106 in a select block 104, source lines 114 coupled to select block 104 as well as unselect blocks 104 in the same plane as select block 104 can be biased with an erase voltage (Vers), such as a high positive bias voltage (e.g., 20 V or more). Memory cells 106 of adjacent NAND memory strings 108 can be coupled through word lines 118 that select which row of memory cells 106 is affected by read and program operations. In some implementations, each word line 118 is coupled to a plurality of memory cells 106. Each word line 118 can include a plurality of control gates (gate electrodes) at each memory cell 106 and a gate line coupling the control gates.

As shown in FIG. 1, memory cell array 101 can include an array of memory cells 106 in a plurality of rows and a plurality of columns in each block 104. One column of memory cells corresponds to one NAND memory string 108, according to some implementations. The plurality of rows of memory cells 106 can be respectively coupled to word lines 118, and the plurality of columns of memory cells 106 can be respectively coupled to bit lines 116. Peripheral circuit 102 can be coupled to memory cell array 101 through bit lines 116 and word lines 118.

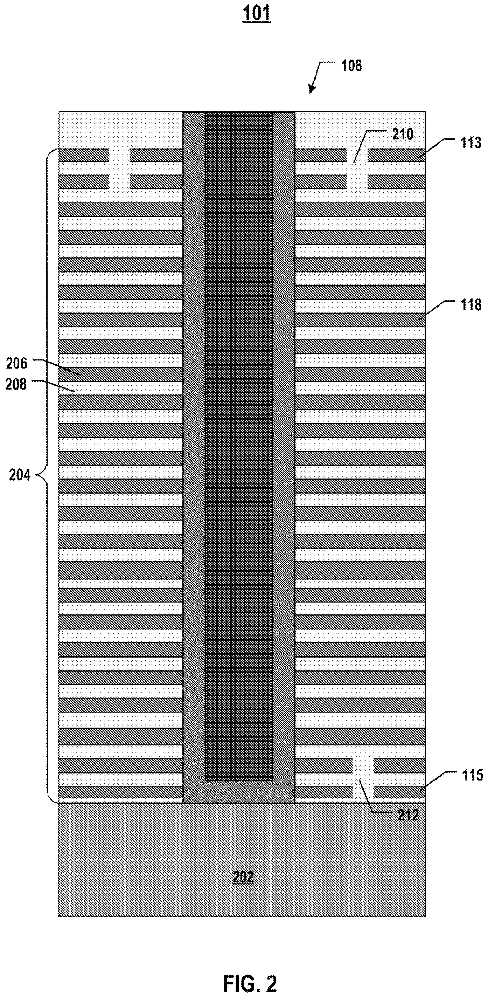

FIG. 2 illustrates a side view of a cross-section of memory cell array 101 including NAND memory string 108, according to some aspects of the present disclosure. As shown in FIG. 2, NAND memory string 108 can extend vertically through a memory stack 204 above a substrate 202. Substrate 202 can include silicon (e.g., single crystalline silicon), silicon germanium (SiGe), gallium arsenide (GaAs), germanium (Ge), silicon on insulator (SOI), germanium on insulator (GOI), or any other suitable materials.

Memory stack 204 can include interleaved gate conductive layers 206 and gate-to-gate dielectric layers 208. The number of the pairs of gate conductive layers 206 and gate-to-gate dielectric layers 208 in memory stack 204 can determine the number of memory cells 106 in memory cell array 101. Gate conductive layer 206 can include conductive materials including, but not limited to, tungsten (W), cobalt (Co), copper (Cu), aluminum (Al), polysilicon, doped silicon, silicides, or any combination thereof. In some implementations, each gate conductive layer 206 includes a metal layer, such as a tungsten layer. In some implementations, each gate conductive layer 206 includes a doped polysilicon layer. Each gate conductive layer 206 can include control gates surrounding memory cells 106, the gates of DSG transistors 112, or the gates of SSG transistors 110, and can extend laterally as DSG line 113 at the top of memory stack 204, SSG line 115 at the bottom of memory stack 204, or word line 118 between DSG line 113 and SSG line 115.

In some implementations, DSG cuts 210 (a.k.a., TSG cuts) are formed through DSG lines 113, which electrically separate DSG lines 113 between adjacent areas (e.g., "sets" referred to herein), such that DSG lines 113 and DSG transistors 112 in different sets may be individually controlled in read and/or program operations. Similarly, in some implementations, SSG cuts 212 (a.k.a., BSG cuts) are formed through SSG lines 115, which electrically separate SSG lines 115 between adjacent regions (e.g., "fingers" referred to herein), such that SSG lines 115 and SSG transistors 110 in different fingers may be individually controlled in read and/or program operations.

As shown in FIG. 2, NAND memory string 108 includes a channel structure extending vertically through memory stack 204. In some implementations, the channel structure includes a channel hole filled with semiconductor material(s) (e.g., as a semiconductor channel) and dielectric material(s) (e.g., as a memory film). It is understood that although not shown in FIG. 2, additional components of memory cell array 101 can be formed including, but not limited to, gate line slits/source contacts, local contacts, interconnect layers, etc.

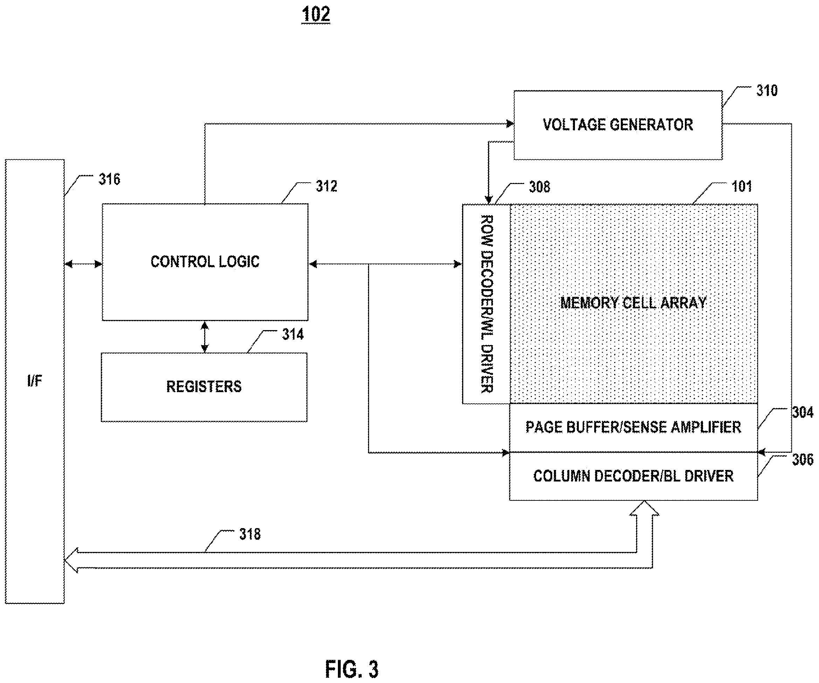

Referring back to FIG. 1, peripheral circuits 102 can be coupled to memory cell array 101 through bit lines 116, word lines 118, source lines 114, SSG lines 115, and DSG lines 113. Peripheral circuits 102 can include any suitable analog, digital, and mixed-signal circuits for facilitating the operations of memory cell array 101 by applying and sensing voltage signals and/or current signals to and from each select memory cell 106 through bit lines 116, word lines 118, source lines 114, SSG lines 115, and DSG lines 113. Peripheral circuits 102 can include various types of peripheral circuits formed using metal-oxide-semiconductor (MOS) technologies. For example, FIG. 3 illustrates some exemplary peripheral circuits including a page buffer/sense amplifier 304, a column decoder/bit line driver 306, a row decoder/word line driver 308, a voltage generator 310, control logic 312, registers 314, an interface (I/F) 316, and a data bus 318. It is understood that in some examples, additional peripheral circuits not shown in FIG. 3 may be included as well.

Page buffer/sense amplifier 304 can be configured to sense (read) and program (write) data from and to memory cell array 101 according to the control signals from control logic 312. In one example, page buffer/sense amplifier 304 may store one or more pages of program data (write data, referred to herein as "data page") to be programmed. In another example, page buffer/sense amplifier 304 may verify programmed select memory cells 106 in each program/verify cycle in a program operation to ensure that the data has been properly programmed into memory cells 106 coupled to select word lines 118. In still another example, page buffer/sense amplifier 304 may also sense the low power signals from bit line 116 that represents a data bit stored in memory cell 106 and amplify the small voltage swing to recognizable logic levels in a read operation.

Column decoder/bit line driver 306 can be configured to be controlled by control logic 312 and select one or more NAND memory strings 108 by applying bit line voltages generated from voltage generator 310. Row decoder/word line driver 308 can be configured to be controlled by control logic 312 and select/deselect blocks 104 of memory cell array 101 and select/deselect word lines 118 of block 104. Row decoder/word line driver 308 can be further configured to drive word lines 118 using word line voltages generated from voltage generator 310. In some implementations, row decoder/word line driver 308 can also select/deselect and drive SSG lines 115 and DSG lines 113 as well. Voltage generator 310 can be configured to be controlled by control logic 312 and generate the word line voltages (e.g., read voltage, program voltage, channel pass voltage, local voltage, verify voltage, etc.), bit line voltages, and source line voltages to be supplied to memory cell array 101.

Control logic 312 can be coupled to each peripheral circuit described above and configured to control the operations of each peripheral circuit. Registers 314 can be coupled to control logic 312 and include status registers, command registers, and address registers for storing status information, command operation codes (OP codes), and command addresses for controlling the operations of each peripheral circuit. Interface 316 can be coupled to control logic 312 and act as a control buffer to buffer and relay control commands received from a memory controller (not shown) and/or a host (not shown) to control logic 312 and status information received from control logic 312 to the memory controller and/or the host. Interface 316 can also be coupled to column decoder/bit line driver 306 via data bus 318 and act as a data input/output (I/O) interface and a data buffer to buffer and relay the data to and from memory cell array 101.

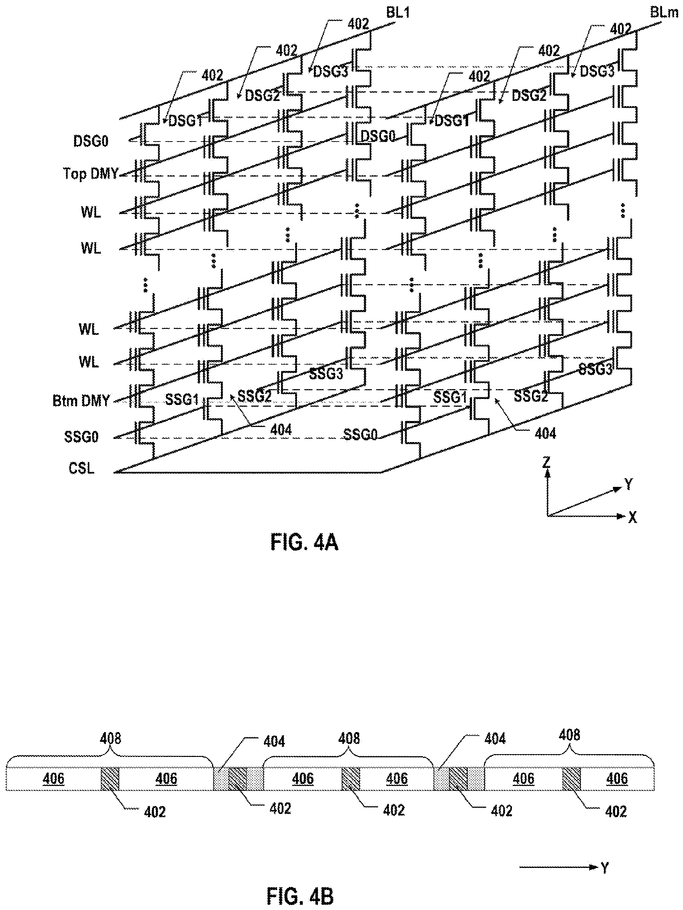

FIGs. 4A and 4B illustrate schematic diagrams of 3D NAND memory strings, according to some aspects of the present disclosure. FIG. 4A shows an example of an array of 3D NAND memory strings (e.g., 108 in FIG. 1) in a block (e.g., 104 in FIG. 1). As shown in FIG. 4A, from top to bottom in the z-direction, each 3D NAND memory string may be coupled to a number of lines in different rows, e.g., DSG lines (DSGs, e.g., 113 in FIG. 1), dummy DSG lines (top DMYs), word lines (WLs, e.g., 118 in FIG. 1), dummy SSG lines (bottom DMYs), SSG line (SSG, e.g., 115 in FIG. 1), and common source line (CSL, e.g., 114 in FIG. 1). As shown in FIG. 4A, in both the word line direction (the x-direction) and the bit line direction (the *y*-direction), the word lines may extend laterally to connect the memory cells of the 3D NAND memory strings. As to the DSG lines and SSG lines, the DSG lines and SSG lines may be continuous in the word line direction (the x-direction) to connect the DSG transistors and SSG transistors of the 3D NAND memory strings at the same position in the *y*-direction (e.g., DSG0 and DSG0, SSG0 and SSG0), but may be separated by DSG cuts 402 and SSG cuts 404 in the bit line direction (the *y*-direction) to form electrically-separated sets 406 and fingers 408, respectively, (shown in FIG. 4B), which can be individually controlled in a program operation.

As shown in FIG. 4B, an array of 3D NAND memory strings can be divided into multiple sets 406 in the bit line direction (the *y*-direction) by DSG cuts 402 that electrically separate DSG line(s) and DSG transistors (e.g., each of DSG0, DSG1, DSG2, and DSG3 is separated in FIG. 4A). As a result, each set 406 of 3D NAND memory strings may be individually controlled in a program operation by individually selected and controlling the respective DSG line. As shown in FIG. 4B, the array of 3D NAND memory strings can also be divided into multiple fingers 408 in the bit line direction (the *y*-direction) by SSG cuts 404 that electrically separate SSG line(s) and SSG transistors (e.g., SSG0 and SSG1 are separated from SSG2 and SSG3 in FIG. 4A). As a result, each finger 408 of 3D NAND memory strings may be individually selected and controlled in a program operation by individually controlling the respective SSG line. Taking FIG. 4A as an example, the array of 3D NAND memory strings may be divided by 3 DSG cuts 402 into 4 sets 406 each including the 3D NAND memory strings having DSG0, DSG1, DSG2, and DSG3, respectively; the array of 3D NAND memory strings may also be divided by 1 SSG cut 404 into 2 fingers 408, one including the 3D NAND memory strings having SSG0 and SSG1, and the other one including the 3D NAND memory strings having SSG2 and SSG3. Consistent with the scope of the present disclosure, in some implementations, an array of 3D memory strings are divided into sets 406 and fingers 408 by DSG cuts 402 and SSG cuts 404, respectively, in a program operation, and each set 406 is the basic unit for program operation for implementing program operation schemes, such as 3 or 4-bit line (3BL or 4BL) bias program.

It is understood that DSG cuts 402 may be implemented as physical cuts that replace parts of the DSG lines with dielectric layers (e.g., DSG cuts 210 shown in FIG. 2), or may be implemented as electrical cuts that pre-program (a.k.a. trim) different DSG transistors to different threshold voltage levels. Similarly, it is understood that SSG cuts 404 may be implemented as physical cuts that replace parts of the SSG lines with dielectric layers (e.g., SSG cuts 212 shown in FIG. 2), or may be implemented as electrical cuts that pre-program (a.k.a. trim) different SSG transistors to different threshold voltage levels. It is also understood that the interval between adjacent DSG cuts 402 or SSG cuts 404 (i.e., the number of 3D NAND memory strings in each set 406 or each finger 408) may vary in different examples.

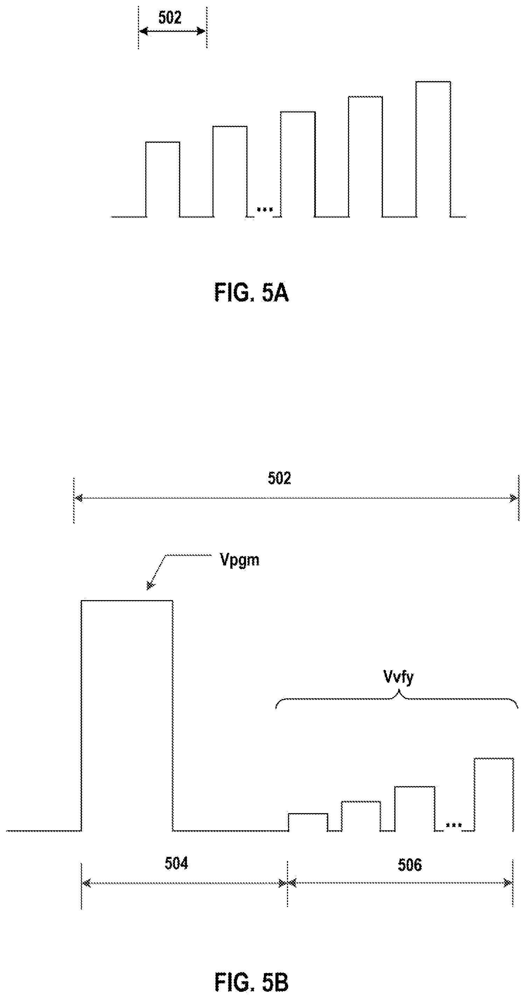

To perform a program operation, in addition to page buffer/sense amplifier 304 providing to each select memory cell 106 the corresponding piece of data, row decoder/word line driver 308 can be configured to apply program voltages and verify voltages to a select word line 118 coupled to a select row of memory cells 106 in one or more program/verify cycles in order to raise the threshold voltage of each select memory cell 106 to a desired level (into a desired range of threshold voltages) based on the corresponding piece of data. For example, FIGs. 5A and 5B illustrate a waveform of word line voltages applied to a select word line in a program operation, according to some aspects of the present disclosure.

As shown in FIGs. 5A and 5B, the program operation includes one or more loops 502, each of which includes a program cycle 504 and a verify cycle 506, according to some implementations. As shown in FIG. 5B, in each loop 502, row decoder/word line driver 308 can be configured to apply a program voltage (Vpgm) on select word line 118 to select row of memory cells 106 in program cycle 504 and sequentially apply one or more verify voltages (Vvfy) with incremental changes of voltage levels to verify select row of memory cells 106 in verify cycle 506. That is, in each loop 502, peripheral circuit 102 can perform verification of select row of memory cells 106 at one or more levels in verify cycle 506 after applying a program voltage in program cycle 504. The number of verify voltages applied in verify cycle 506 depends on the level being programmed by the specific loop 502, according to some implementations. As a result, at the end of the program operation, for example, select memory cell 106 may be programmed into one of the 2*^{N}* levels based on the corresponding *N* bits of data to be stored in select memory cell 106, where N is a positive integer.

In some implementations, the program operation is an incremental step pulse program (ISPP), which gradually increases the program voltage on a step-voltage basis in different loops 502. The magnitude of this "step" (e.g., the increase in magnitude of the program voltage in each loop 502 relative to the program voltage in the immediately previous loop 502) is known as the "pulse step height." Consistent with the scope of the present disclosure, in some implementations, the program operation includes at least a first loop 502 and a second loop 502 after the first loop 502, and the first loop 502 and the second loop 502 are the starting loop and the ending loop of ISPP, respectively.

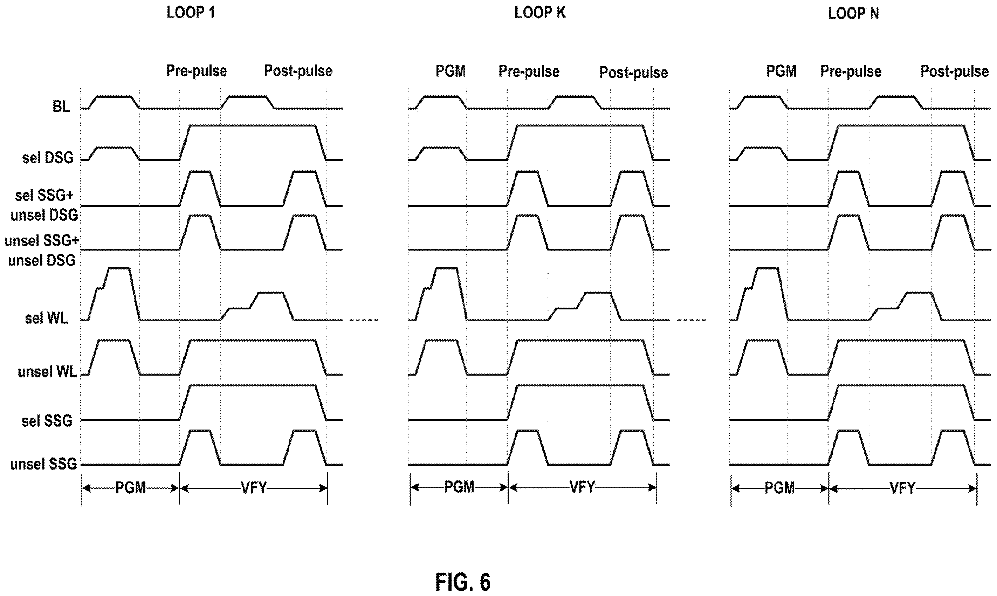

FIG. 6 illustrates timing diagrams of a program operation having multiple loops. The program operation can be ISPP including a plurality of loops (e.g., *N* loops), such as a starting loop and an ending loop after the starting loop. For example, as shown in FIG. 6, the program operation may include the starting loop (loop 1), the ending loop (loop n), and at least one middle loop (loop k) between the starting loop and ending loop. Each loop of the program operation may include a program cycle (PGM) and a verify cycle (VFY), as described above in FIGs. 5A and 5B. Each verify cycle may include a verify period (phase) in which one or more verify voltage pulses are applied to select word line (sel WL) to verify select memory cells coupled to the select word line at one or more levels. As shown in FIG. 6, each verify cycle may also include a pre-pulse period (phase) immediately before the verify period in which the NAND memory strings get ready for verification. As shown in FIG. 6, each verify cycle may further include a post-pulse period (phase) (a.k.a., recovery period) immediately after the verify period in which the NAND memory strings become recovered from verification and get ready for another operation (e.g., read operation) after the ending loop or get ready for programming in the next loop after any non-ending loops.

As shown in FIG. 6, for each select NAND memory string, a select voltage (e.g., a positive voltage) may be applied to each select DSG line and select SSG line to turn on each select DSG transistor and select SSG transistor during the verify period of each loop in order to verify the select memory cells of each select NAND memory string in the verify period. In contrast, for each unselect NAND memory string, a deselect voltage (e.g., a ground voltage) may be applied to each unselect DSG line and unselect SSG line to turn off each unselect DSG transistor and unselect SSG transistor in the verify period of each loop to inhibit the verification of the unselect memory cells of each unselect NAND memory string in the verify period.

On the other hand, the channel potential of an unselect NAND memory string may be up-coupled to a positive potential in the pre-pulse period, thereby causing HCI in the channel between the DSG transistor and SSG transistor. Thus, as shown in FIG. 6, in the pre-pulse period of each loop, a select voltage may be applied to each unselect DSG line and unselect SSG line to turn on each unselect DSG transistor and unselect SSG transistor in order to decrease the channel potential and eliminate HCI before the verify period, also known as "pre-pulse channel cleaning." Similarly, the channel potential of an unselect NAND memory string may be down-coupled to a negative potential in the post-pulse period, causing HCI as well in the channel between the DSG transistor and SSG transistor. Thus, as shown in FIG. 6, in the post-pulse period of each loop, a select voltage may be applied to each unselect DSG line and unselect SSG line to turn on each unselect DSG transistor and unselect SSG transistor again in order to increase the channel potential and eliminate HCI before the next operation, also known as "post-pulse channel cleaning." The pre-pulse channel cleaning and post-pulse channel cleaning performed in each loop (e.g., in each of loop 1 to loop n in FIG. 6), however, prolong the duration of each verify cycle, thereby becoming the bottleneck of saving program time.

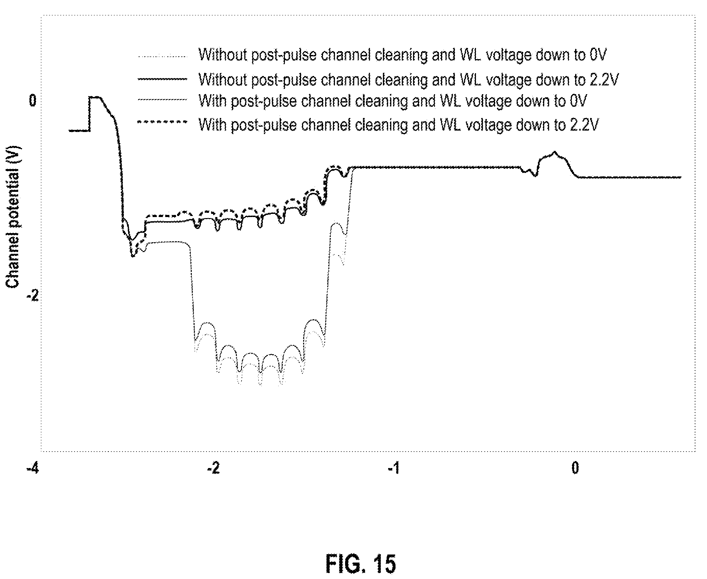

The inventors of the present disclosure discovered that the post-pulse channel cleaning performed in the early loops may be skipped without significantly impacting channel potential, in particular when SSG cuts are implemented to separate 3D NAND memory strings into fingers. For example, as reflected in the simulation results of FIG. 15 using Technology Computer-Aided Design (TCAD) simulation, the post-pulse channel cleaning performed in the early loops does not have a significant impact on the channel potential. Accordingly, the present disclosure provides various "by-loop" channel cleaning schemes that do not clean the channels of unselect memory strings in both the pre-pulse period and post-pulse period in each verify cycle, thereby saving program time without sacrificing performance. For example, since the unselected DSG transistors may be turned off during certain periods (e.g., pre-pulse and/or post-pulse periods), the load may be reduced, thereby reducing the ramping time of the word line voltages.

According to some aspects of the present disclosure, the channel cleaning is skipped in the pre-pulse period and post-pulse period of the verify cycle(s) in the early loop(s), for example, only performed in the pre-pulse period and/or the post-pulse period of the verify cycle in the ending loop (i.e., the last verify cycle). In some implementations, in the pre-pulse period and the post-pulse period in a first loop of a program operation, the DSG transistor in an unselect memory string is turned off, and in at least one of the pre-pulse period or the post-pulse period in a second loop of the program operation after the first loop, the DSG transistor in the unselect memory string is turned on. That is, in at least one of the early loops (i.e., the first loop, e.g., the starting loop of ISPP), at least the DSG transistor in an unselect memory string can be turned off to skip the pre-pulse channel cleaning and post-pulse channel cleaning in that loop to save program time.

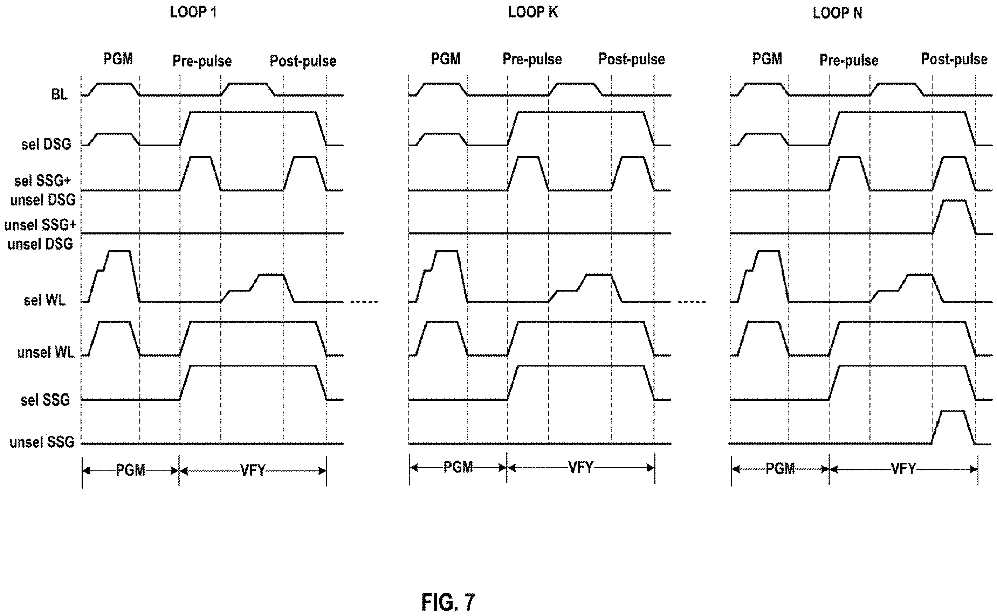

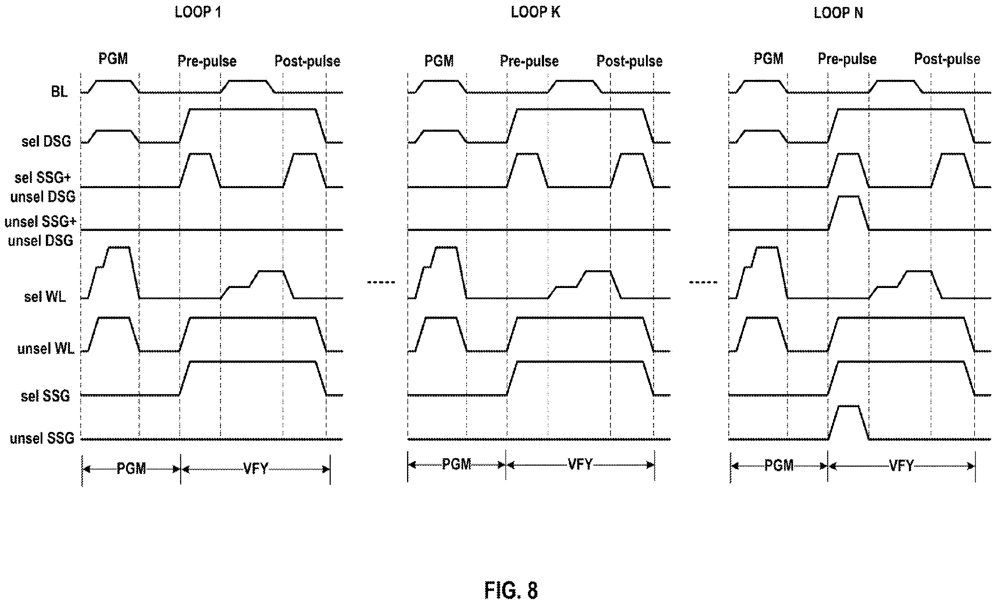

For example, FIGs. 7 and 8 illustrate timing diagrams of program operations having multiple loops, according to some aspects of the present disclosure. The DSG transistor in the select memory string can be electrically separated from the DSG transistor in the unselect memory string by a DSG cut; the SSG transistor in the select memory string can be electrically separated from the SSG transistor in the unselect memory string by an SSG cut. As shown in FIGs. 7 and 8, in each loop (e.g., loop 1, loop k, and loop n), word line driver 308 of peripheral circuit 102 can be configured to apply a select voltage (e.g., a positive voltage) to the select SSG line (sel SSG) and the select SSG transistor in the select NAND memory string to turn on the select SSG transistor in both the pre-pulse period and the post-pulse period. Similarly, in each loop (e.g., loop 1, loop k, and loop n), word line driver 308 of peripheral circuit 102 can be configured to apply a select voltage (e.g., a positive voltage) to the select DSG line (sel DSG) and the select DSG transistor in the select NAND memory string to turn on the select DSG transistor in both the pre-pulse period and the post-pulse period.

In contrast, as shown in FIGs. 7 and 8, in each of the non-ending loops (e.g., loop 1 and loop k), word line driver 308 of peripheral circuit 102 can be configured to apply a deselect voltage (e.g., the ground voltage) to the unselect SSG line (unsel SSG) and the unselect SSG transistor in the unselect NAND memory string to turn off the unselect SSG transistor in both the pre-pulse period and the post-pulse period. Similarly, in each of the non-ending loops (e.g., loop 1 and loop k), word line driver 308 of peripheral circuit 102 can be configured to apply a deselect voltage (e.g., the ground voltage) to the unselect DSG line (unsel SSG + unsel DSG) and the unselect DSG transistor in the unselect NAND memory string to turn off the unselect DSG transistor in both the pre-pulse period and the post-pulse period. In other words, both the pre-pulse channel cleaning and post-pulse channel cleaning can be skipped for unselect NAND memory strings (e.g., having unselect SSG transistor and unselect DSG transistor) in each of the non-ending loops, thereby saving the program time.

It is noted that sel SSG + unsel DSG, as shown in FIGs. 6-10, refers to the waveform of the voltage signal applied to the unselect DSG line in fingers 408 of select SSG lines (and select SSG transistors), as shown in FIGs. 4A and 4B, while unsel SSG + unsel DSG, as shown in FIGs. 6-10, refers to the waveform of the voltage signal applied to the unselect DSG line in fingers 408 of unselect SSG lines (and unselect SSG transistors), as shown in FIGs. 4A and 4B.

To still be able to return the channel potential back to normal and eliminate HCI before the next operation (e.g., a read operation), in the ending loop (e.g., loop n), word line driver 308 of peripheral circuit 102 can be configured to apply a select voltage (e.g., a positive voltage) to the unselect SSG line (unsel SSG) and the unselect SSG transistor in the unselect NAND memory string to turn on the unselect SSG transistor in the post-pulse period (as shown in FIG. 7) or in the pre-pulse period (as shown in FIG. 8). Similarly, in the ending loop (e.g., loop n), word line driver 308 of peripheral circuit 102 can be configured to apply a select voltage (e.g., a positive voltage) to the unselect DSG line (unsel SSG + unsel DSG) and the unselect DSG transistor in the unselect NAND memory string to turn on the unselect DSG transistor in the post-pulse period (as shown in FIG. 7) or in the pre-pulse period (as shown in FIG. 8). Although not shown, it is understood that in some examples, word line driver 308 may be configured to apply a select voltage (e.g., a positive voltage) to the unselect SSG line (unsel SSG) and the unselect SSG transistor in the unselect NAND memory string to turn on the unselect SSG transistor in both the post-pulse period and the pre-pulse period. Similarly, word line driver 308 may be configured to apply a select voltage (e.g., a positive voltage) to the unselect DSG line (unsel SSG + unsel DSG) and the unselect DSG transistor in the unselect NAND memory string to turn on the unselect DSG transistor in both the post-pulse period and the pre-pulse period. It is also understood that although pre-pulse channel cleaning and post-pulse channel cleaning are skipped in each of the non-ending loops, as shown in FIGs. 7 and 8, in some examples, pre-pulse channel cleaning and post-pulse channel cleaning may be skipped in at least one of the non-ending loops, which can still save the program time.

As shown in FIGs. 7 and 8, in each loop (e.g., loop 1, loop k, and loop n), word line driver 308 of peripheral circuit 102 can be configured to apply a deselect voltage (e.g., the ground voltage) to the unselect SSG line (unsel SSG) and the unselect SSG transistor in the unselect NAND memory string to turn off the unselect SSG transistor in the verify period between the pre-pulse and post-pulse periods. That is, in each loop, word line driver 308 can be configured to apply the deselect voltage to the unselect SSG line (unsel SSG) and the unselect SSG transistor in the unselect NAND memory string to turn off the unselect SSG transistor in the entire verify cycle. Similarly, in each loop (e.g., loop 1, loop k, and loop n), word line driver 308 of peripheral circuit 102 can be configured to apply a deselect voltage (e.g., the ground voltage) to the unselect DSG line (unsel SSG + unsel DSG) and the unselect DSG transistor in the unselect NAND memory string to turn off the unselect DSG transistor in the verify period between the pre-pulse and post-pulse periods. That is, in each loop, word line driver 308 can be configured to apply the deselect voltage to the unselect DSG line (unsel SSG + unsel DSG) and the unselect DSG transistor in the unselect NAND memory string to turn off the unselect DSG transistor in the entire verify cycle.

In contrast, as shown in FIGs. 7 and 8, in each loop (e.g., loop 1, loop k, and loop n), word line driver 308 of peripheral circuit 102 can be configured to apply a select voltage (e.g., a positive voltage) to the select SSG line (sel SSG) and the select SSG transistor in the select NAND memory string to turn on the select SSG transistor in the verify period between the pre-pulse period and the post-pulse period. That is, in each loop, word line driver 308 can be configured to apply the select voltage to the select SSG line (sel SSG) and the select SSG transistor in the select NAND memory string to turn on the select SSG transistor in the entire verify cycle. Similarly, in each loop (e.g., loop 1, loop k, and loop n), word line driver 308 of peripheral circuit 102 can be configured to apply a select voltage (e.g., a positive voltage) to the select DSG line (sel DSG) and the select DSG transistor in the select NAND memory string to turn on the select DSG transistor in the verify period between the pre-pulse period and the post-pulse period. That is, in each loop, word line driver 308 can be configured to apply the select voltage to the select DSG line (sel DSG) and the select DSG transistor in the select NAND memory string to turn on the select DSG transistor in the entire verify cycle.

According to some aspects of the present disclosure, the channel cleaning is performed in only one of the pre-pulse and post-pulse periods, but not both, in each verify cycle. In some implementations, in only one of the pre-pulse period or the post-pulse period in a first loop of a program operation, the DSG transistor in an unselect memory string is turned on, and in only one of the pre-pulse period or the post-pulse period in a second loop of the program operation after the first loop, the DSG transistor in the unselect memory string is turned on.

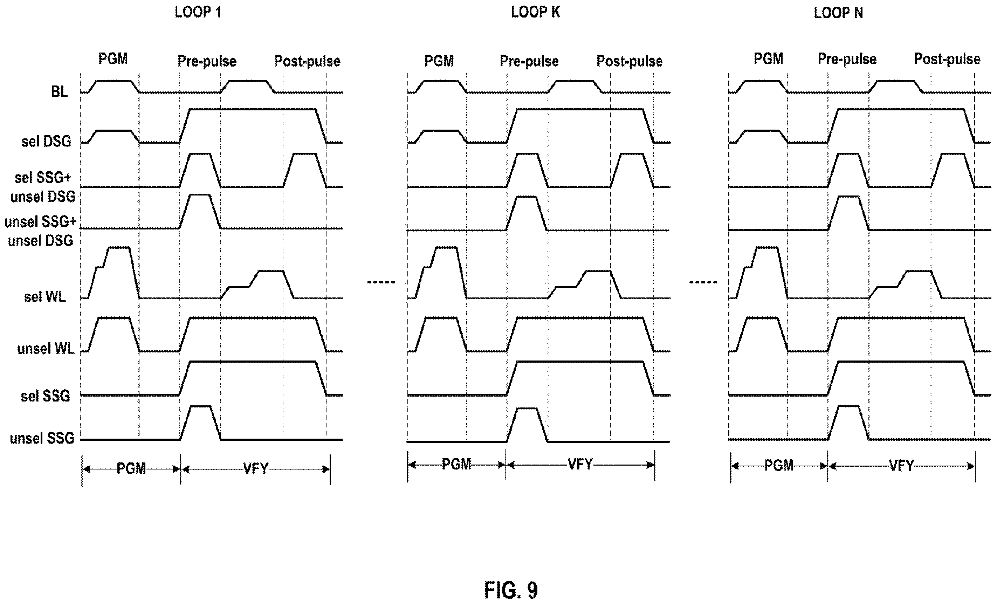

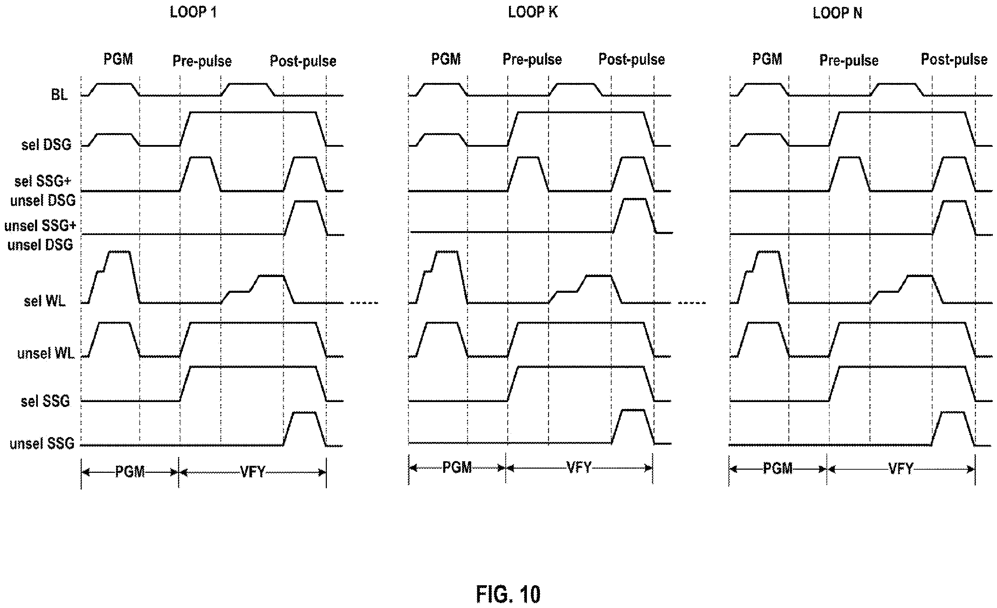

For example, FIGs. 9 and 10 illustrate timing diagrams of program operations having multiple loops, according to some aspects of the present disclosure. The DSG transistor in the select memory string can be electrically separated from the DSG transistor in the unselect memory string by a DSG cut; the SSG transistor in the select memory string can be electrically separated from the SSG transistor in the unselect memory string by an SSG cut. As shown in FIGs. 9 and 10, in each loop (e.g., loop 1, loop k, and loop n), word line driver 308 of peripheral circuit 102 can be configured to apply a select voltage (e.g., a positive voltage) to the select SSG line (sel SSG) and the select SSG transistor in the select NAND memory string to turn on the select SSG transistor in both the pre-pulse period and the post-pulse period. Similarly, in each loop (e.g., loop 1, loop k, and loop n), word line driver 308 of peripheral circuit 102 can be configured to apply a select voltage (e.g., a positive voltage) to the select DSG line (sel DSG) and the select DSG transistor in the select NAND memory string to turn on the select DSG transistor in both the pre-pulse period and the post-pulse period.

In contrast, in each loop (e.g., loop 1, loop k, and loop n), word line driver 308 of peripheral circuit 102 can be configured to apply a select voltage (e.g., a positive voltage) to the unselect SSG line (unsel SSG) and the unselect SSG transistor in the unselect NAND memory string to turn on the unselect SSG transistor in either the pre-pulse period (as shown in FIG. 9) or the post-pulse period (as shown in FIG. 10), but not both. Similarly, in each of loops (e.g., loop 1, loop k, and loop n), word line driver 308 of peripheral circuit 102 can be configured to apply a select voltage (e.g., a positive voltage) to the unselect DSG line (unsel SSG + unsel DSG) and the unselect DSG transistor in the unselect NAND memory string to turn on the unselect DSG transistor in either the pre-pulse period (as shown in FIG. 9) or the post-pulse period (as shown in FIG. 10), but not both. In other words, either the pre-pulse channel cleaning or the post-pulse channel cleaning, but not both, can be performed for unselect NAND memory strings (e.g., having unselect SSG transistor and unselect DSG transistor) in each loop, thereby saving the program time. It is also understood that although pre-pulse channel cleaning or post-pulse channel cleaning is skipped in each loop, as shown in FIGs. 9 and 10, in some examples, pre-pulse channel cleaning and post-pulse channel cleaning may be both performed in one or some of the loops, but not all the loops, which can still save the program time.

As shown in FIGs. 9 and 10, in each loop (e.g., loop 1, loop k, and loop n), word line driver 308 of peripheral circuit 102 can be configured to apply a deselect voltage (e.g., the ground voltage) to the unselect SSG line (unsel SSG) and the unselect SSG transistor in the unselect NAND memory string to turn off the unselect SSG transistor in the verify period between the pre-pulse and post-pulse periods. Similarly, in each loop (e.g., loop 1, loop k, and loop n), word line driver 308 of peripheral circuit 102 can be configured to apply a deselect voltage (e.g., the ground voltage) to the unselect DSG line (unsel SSG + unsel DSG) and the unselect DSG transistor in the unselect NAND memory string to turn off the unselect DSG transistor in the verify period between the pre-pulse and post-pulse periods.

In contrast, as shown in FIGs. 9 and 10, in each loop (e.g., loop 1, loop k, and loop n), word line driver 308 of peripheral circuit 102 can be configured to apply a select voltage (e.g., a positive voltage) to the select SSG line (sel SSG) and the select SSG transistor in the select NAND memory string to turn on the select SSG transistor in the verify period between the pre-pulse period and the post-pulse period. That is, in each loop, word line driver 308 can be configured to apply the select voltage to the select SSG line (sel SSG) and the select SSG transistor in the select NAND memory string to turn on the select SSG transistor in the entire verify cycle. Similarly, in each loop (e.g., loop 1, loop k, and loop n), word line driver 308 of peripheral circuit 102 can be configured to apply a select voltage (e.g., a positive voltage) to the select DSG line (sel DSG) and the select DSG transistor in the select NAND memory string to turn on the select DSG transistor in the verify period between the pre-pulse period and the post-pulse period. That is, in each loop, word line driver 308 can be configured to apply the select voltage to the select DSG line (sel DSG) and the select DSG transistor in the select NAND memory string to turn on the select DSG transistor in the entire verify cycle.

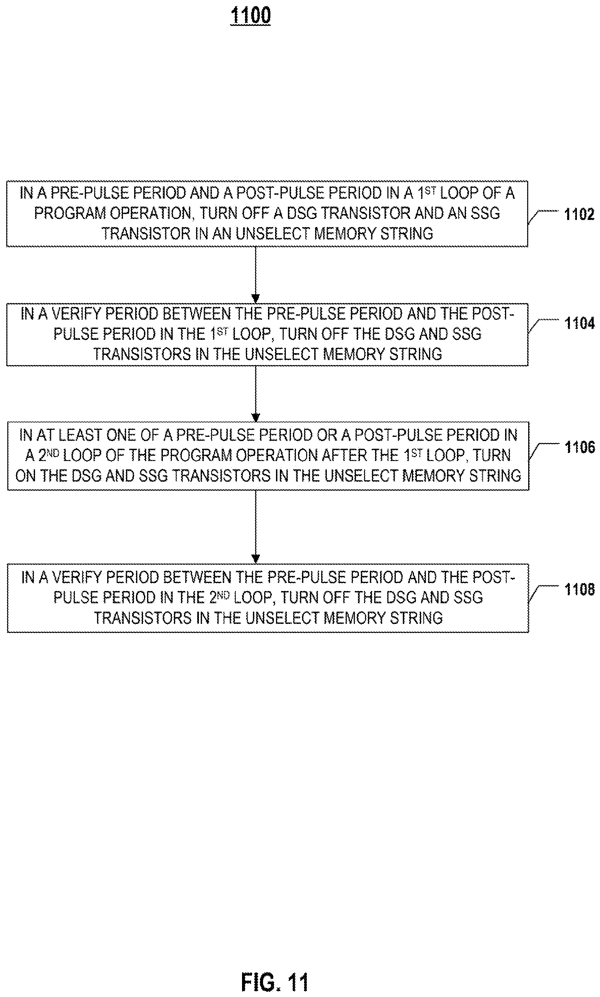

FIG. 11 illustrates a flowchart of a method 1100 for programming a memory device, according to some aspects of the present disclosure. The memory device may be any suitable memory device disclosed herein, such as memory device 100. Method 1100 may be implemented by peripheral circuit 102, such as row decoder/word line driver 308, page buffer/sense amplifier 304, and control logic 312. It is understood that the operations shown in method 1100 may not be exhaustive and that other operations can be performed as well before, after, or between any of the illustrated operations. Further, some of the operations may be performed simultaneously, or in a different order than shown in FIG. 11.

Referring to FIG. 11, method 1100 starts at operation 1102, in which in a pre-pulse period and a post-pulse period in a first loop of a program operation, a DSG transistor and an SSG transistor in an unselect memory string are turned off. Method 1100 proceeds to operation 1104, as illustrated in FIG. 11, in which in a verify period between the pre-pulse period and the post-pulse period in the first loop of the program operation, the DSG transistor and the SSG transistor in the unselect memory string are turned off. For example, as shown in FIGs. 1-3, 7, and 8, in loop 1 or loop k of the program operation, unselect DSG transistor 112 and unselect SSG transistor 110 may be turned off in the pre-pulse, verify, and post-pulse periods by applying the ground voltage to unselect DSG line 113 (unsel SSG + unsel DSG) and unselect SSG line 115 (unsel SSG) through the verify cycle by word line driver 308 of peripheral circuit 102.

Method 1100 proceeds to operation 1106, as illustrated in FIG. 11, in at least one of a pre-pulse period or a post-pulse period in a second loop of the program operation after the first loop, the DSG transistor and the SSG transistor in the unselect memory string are turned on. For example, as shown in FIGs. 1-3, 7, and 8, in loop n of the program operation, unselect DSG transistor 112 and unselect SSG transistor 110 may be turned on in the pre-pulse period (FIG. 8) or in the post-pulse period (FIG. 7) by applying a positive voltage to unselect DSG line 113 (unsel SSG + unsel DSG) and unselect SSG line 115 (unsel SSG) in the pre-pulse period (FIG. 8) or in the post-pulse period (FIG. 7) by word line driver 308 of peripheral circuit 102.

Method 1100 proceeds to operation 1108, as illustrated in FIG. 11, in which in a verify period between the pre-pulse period and the post-pulse period in the second loop of the program operation, the DSG transistor and the SSG transistor in the unselect memory string are turned off. For example, as shown in FIGs. 1-3, 7, and 8, in loop n of the program operation, unselect DSG transistor 112 and unselect SSG transistor 110 may be turned off in the verify period by applying the ground voltage to unselect DSG line 113 (unsel SSG + unsel DSG) and unselect SSG line 115 (unsel SSG) in the verify period by word line driver 308 of peripheral circuit 102.

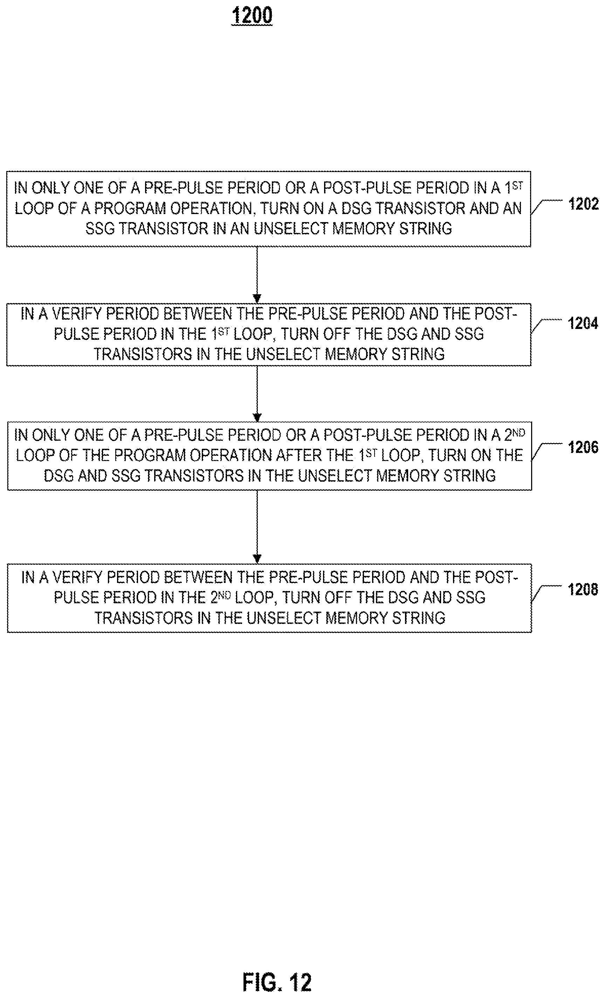

FIG. 12 illustrates a flowchart of another method 1200 for programming a memory device, according to some aspects of the present disclosure. The memory device may be any suitable memory device disclosed herein, such as memory device 100. Method 1200 may be implemented by peripheral circuit 102, such as row decoder/word line driver 308, page buffer/sense amplifier 304, and control logic 312. It is understood that the operations shown in method 1200 may not be exhaustive and that other operations can be performed as well before, after, or between any of the illustrated operations. Further, some of the operations may be performed simultaneously, or in a different order than shown in FIG. 12.

Referring to FIG. 12, method 1200 starts at operation 1202, in which in only one of a pre-pulse period or a post-pulse period in a first loop of the program operation, a DSG transistor and an SSG transistor in an unselect memory string are turned on. For example, as shown in FIGs. 1-3, 9, and 10, in loop 1 or loop k of the program operation, unselect DSG transistor 112 and unselect SSG transistor 110 may be turned on in the pre-pulse period, but not in the post-pulse period (FIG. 9) or in the post-pulse period, but not in the pre-pulse period (FIG. 10) by applying a positive voltage to unselect DSG line 113 (unsel SSG + unsel DSG) and unselect SSG line 115 (unsel SSG) in the pre-pulse period, but not in the post-pulse period (FIG. 9) or in the post-pulse period, but not in the pre-pulse period (FIG. 10) by word line driver 308 of peripheral circuit 102.

Method 1200 proceeds to operation 1204, as illustrated in FIG. 12, in which in a verify period between the pre-pulse period and the post-pulse period in the first loop of the program operation, the DSG transistor and the SSG transistor in the unselect memory string are turned off. For example, as shown in FIGs. 1-3, 9, and 10, in loop 1 or loop k of the program operation, unselect DSG transistor 112 and unselect SSG transistor 110 may be turned off in the verify period by applying the ground voltage to unselect DSG line 113 (unsel SSG + unsel DSG) and unselect SSG line 115 (unsel SSG) in the verify period by word line driver 308 of peripheral circuit 102.

Method 1200 proceeds to operation 1206, as illustrated in FIG. 12, in which in only one of a pre-pulse period or a post-pulse period in a second loop of the program operation after the first loop, the DSG transistor and the SSG transistor in the unselect memory string are turned on. For example, as shown in FIGs. 1-3, 9, and 10, in loop n of the program operation, unselect DSG transistor 112 and unselect SSG transistor 110 may be turned on in the pre-pulse period, but not in the post-pulse period (FIG. 9) or in the post-pulse period, but not in the pre-pulse period (FIG. 10) by applying a positive voltage to unselect DSG line 113 (unsel SSG + unsel DSG) and unselect SSG line 115 (unsel SSG) in the pre-pulse period, but not in the post-pulse period (FIG. 9) or in the post-pulse period, but not in the pre-pulse period (FIG. 10) by word line driver 308 of peripheral circuit 102.

Method 1200 proceeds to operation 1208, as illustrated in FIG. 12, in which in a verify period between the pre-pulse period and the post-pulse period in the second loop of the program operation, the DSG transistor and the SSG transistor in the unselect memory string are turned off. For example, as shown in FIGs. 1-3, 9, and 10, in loop n of the program operation, unselect DSG transistor 112 and unselect SSG transistor 110 may be turned off in the verify period by applying the ground voltage to unselect DSG line 113 (unsel SSG + unsel DSG) and unselect SSG line 115 (unsel SSG) in the verify period by word line driver 308 of peripheral circuit 102

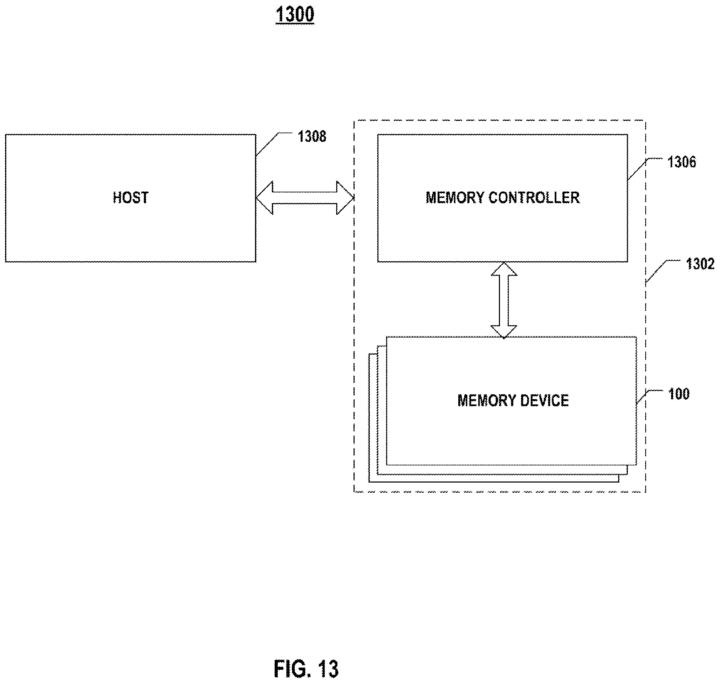

FIG. 13 illustrates a block diagram of a system 1300 having a memory device, according to some aspects of the present disclosure. System 1300 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 13, system 1300 can include a host 1308 and a memory system 1302 having one or more memory devices 100 (shown in FIG. 1) and a memory controller 1306. Host 1308 can be a processor of an electronic device, such as a central processing unit (CPU), or a system-on-chip (SoC), such as an application processor (AP). Host 1308 can be configured to send or receive data to or from memory devices 100.

Memory device 100 can be any memory device disclosed in the present disclosure. Memory controller 1306 is coupled to memory device 100 and host 1308 and is configured to control memory device 100, according to some implementations. Memory controller 1306 can manage the data stored in memory device 100 and communicate with host 1308. In some implementations, memory controller 1306 is designed for operating in a low duty-cycle environment like secure digital (SD) cards, compact Flash (CF) cards, universal serial bus (USB) Flash drives, or other media for use in electronic devices, such as personal computers, digital cameras, mobile phones, etc. In some implementations, memory controller 1306 is designed for operating in a high duty-cycle environment SSDs or embedded multi-media-cards (eMMCs) used as data storage for mobile devices, such as smartphones, tablets, laptop computers, etc., and enterprise storage arrays. Memory controller 1306 can be configured to control operations of memory device 100, such as read, erase, and program operations. Memory controller 1306 can also be configured to manage various functions with respect to the data stored or to be stored in memory device 100 including, but not limited to bad-block management, garbage collection, logical-to-physical address conversion, wear leveling, etc. In some implementations, memory controller 1306 is further configured to process error correction codes (ECCs) with respect to the data read from or written to memory device 100. Any other suitable functions may be performed by memory controller 1306 as well, for example, formatting memory device 100. Memory controller 1306 can communicate with an external device (e.g., host 1308) according to a particular communication protocol. For example, memory controller 1306 may communicate with the external device through at least one of various interface protocols, such as a USB protocol, a multimedia card (MMC) protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

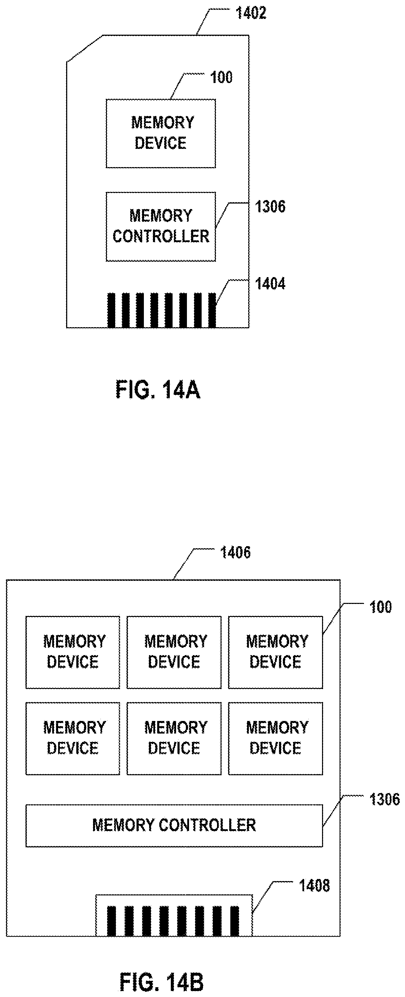

Memory controller 1306 and one or more memory devices 100 can be integrated into various types of storage devices, for example, being included in the same package, such as a universal Flash storage (UFS) package or an eMMC package. That is, memory system 1302 can be implemented and packaged into different types of end electronic products. In one example as shown in FIG. 14A, memory controller 1306 and a single memory device 100 may be integrated into a memory card 1402. Memory card 1402 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. Memory card 1402 can further include a memory card connector 1404 coupling memory card 1402 with a host (e.g., host 1308 in FIG. 14). In another example as shown in FIG. 14B, memory controller 1306 and multiple memory devices 100 may be integrated into an SSD 1406. SSD 1406 can further include an SSD connector 1408 coupling SSD 1406 with a host (e.g., host 1308 in FIG. 13). In some implementations, the storage capacity and/or the operation speed of SSD 1406 is greater than those of memory card 1402.

The foregoing description of the specific implementations can be readily modified and/or adapted for various applications in accordance with the following claims.

## Claims

1. A memory device (100), comprising:
memory strings (108) each comprising a drain select gate (DSG) transistor (112), memory cells (106), and a source select gate (SSG) transistor (110), wherein the memory device is a NAND Flash memory device; and
a peripheral circuit (102) coupled to the memory strings (108) and configured to, in a program operation, program a select memory cell of the memory cells (106) in a select memory string of the memory strings (108), and inhibit an unselect memory cell of the memory cells (106) in an unselect memory string of the memory strings (108), the peripheral circuit (102) being **characterized by**:
a word line driver (308) configured to:
in a pre-pulse period and a post-pulse period in a verify cycle (506) of a first loop of the program operation, the first loop including a program cycle (504) and the verify cycle (506), turn off the DSG transistor (112) in the unselect memory string; and
in at least one of a pre-pulse period or a post-pulse period in a verify cycle (506) of a second loop of the program operation after the first loop, the second loop including a program cycle (504) and the verify cycle (506), turn on the DSG transistor (112) in the unselect memory string.

2. The memory device (100) of claim 1, wherein the program operation is an incremental step pulse program (ISPP), and the first loop and the second loop are a starting loop and an ending loop of the ISPP, respectively.

3. The memory device (100) of claim 1 or 2, wherein the word line driver is further configured to:
in the pre-pulse period and the post-pulse period in the first loop of the program operation, turn off the SSG transistor (110) in the unselect memory string; and
in the at least one of the pre-pulse period or the post-pulse period in the second loop of the program operation, turn on the SSG transistor (110) in the unselect memory string.

4. The memory device of claim 3, wherein the word line driver (308) is further configured to:
in a verify period between the pre-pulse period and the post-pulse period in the first loop of the program operation, turn off the DSG transistor (112) and the SSG transistor (110) in the unselect memory string; and
in a verify period between the pre-pulse period and the post-pulse period in the second loop of the program operation, turn off the DSG transistor (112) and the SSG transistor (110) in the unselect memory string.

5. The memory device of claim 3 or 4, wherein the word line driver (308) is further configured to:
in the pre-pulse period in the second loop of the program operation, turn off the DSG transistor (112) and the SSG transistor (110) in the unselect memory string; and
in the post-pulse period in the second loop of the program operation, turn on the DSG transistor (112) and the SSG transistor (110) in the unselect memory string.

6. The memory device of claim 3 or 4, wherein the word line driver (308) is further configured to:
in the pre-pulse period in the second loop of the program operation, turn on the DSG transistor (112) and the SSG transistor (110) in the unselect memory string; and
in the post-pulse period in the second loop of the program operation, turn off the DSG transistor (112) and the SSG transistor (110) in the unselect memory string.

7. The memory device of any one of claims 1-6, wherein the DSG transistor (112) in the select memory string is electrically separated from the DSG transistor (112) in the unselect memory string.

8. A method for operating the memory device according to one of claims 1 to 7, the method being **characterized by**:
in a pre-pulse period and a post-pulse period in a verify cycle of a first loop of a program operation, the first loop including a program cycle (504) and the verify cycle (506), turning off the DSG transistor (112) in an unselect memory string of the memory strings; and
in at least one of a pre-pulse period or a post-pulse period in a verify cycle of a second loop of the program operation after the first loop, the second loop including a program cycle (504) and the verify cycle (506), turning on the DSG transistor (112) in the unselect memory string.

9. The method of claim 8, wherein the program operation is an incremental step pulse program (ISPP), and the first loop and the second loop are a starting loop and an ending loop of the ISPP, respectively.

10. The method of claim 8 or 9, further comprising:
in the pre-pulse period and the post-pulse period in the first loop of the program operation, turning off the SSG transistor (110) in the unselect memory string; and
in the at least one of the pre-pulse period or the post-pulse period in the second loop of the program operation, turning on the SSG transistor (110) in the unselect memory string.

11. The method of claim 10, further comprising:
in a verify period between the pre-pulse period and the post-pulse period in the first loop of the program operation, turning off the DSG transistor (112) and the SSG transistor (110) in the unselect memory string; and
in a verify period between the pre-pulse period and the post-pulse period in the second loop of the program operation, turning off the DSG transistor (112) and the SSG transistor (110) in the unselect memory string.

12. The method of claim 10 or 11, further comprising:
in the pre-pulse period in the second loop of the program operation, turning off the DSG transistor (112) and the SSG transistor (110) in the unselect memory string; and
in the post-pulse period in the second loop of the program operation, turning on the DSG transistor (112) and the SSG transistor (110) in the unselect memory string.

13. The method of claim 10 or 11, further comprising:
in the pre-pulse period in the second loop of the program operation, turning on the DSG transistor (112) and the SSG transistor (110) in the unselect memory string; and
in the post-pulse period in the second loop of the program operation, turning off the DSG transistor (112) and the SSG transistor (110) in the unselect memory string.

14. The method of any one of claims 8-13, wherein the DSG transistor (112) in a select memory string is electrically separated from the DSG transistor (112) in the unselect memory string.

15. A system, comprising:
a memory device (100) configured to store data according to one of claims 1 to 7; and
a memory controller (1306) coupled to the memory device and configured to control the memory device.

## Patentansprüche

1. Speichervorrichtung (100), umfassend:
Speicherstrings (108), die jeweils einen Drain-Select-Gate (DSG)-Transistor (112), Speicherzellen (106) und einen Source-Select-Gate(SSG)-Transistor (110) umfassen, wobei die Speichervorrichtung eine NAND-Flashspeichervorrichtung ist; und
eine Peripherieschaltung (102), die mit den Speicherstrings (108) verbunden ist und dazu ausgebildet ist, bei einem Programmiervorgang eine ausgewählte Speicherzelle der Speicherzellen (106) in einem ausgewählten Speicherstring der Speicherstrings (108) zu programmieren und eine nicht ausgewählte Speicherzelle der Speicherzellen (106) in einem nicht ausgewählten Speicherstring der Speicherstrings (108) zu sperren, wobei die Peripherieschaltung (102) **gekennzeichnet ist durch**:
einen Wortleitungstreiber (308), der konfiguriert ist:
zum Abschalten des DSG-Transistors (112) in dem nicht ausgewählten Speicherstring in einer Vorimpulsperiode und einer Nachimpulsperiode in einem Verifizierungszyklus (506) einer ersten Schleife des Programmiervorgangs, wobei die erste Schleife einen Programmierzyklus (504) und den Verifizierungszyklus (506) enthält; und
zum Anschalten des DSG-Transistors (112) in dem nicht ausgewählten Speicherstring in zumindest einer Vorimpulsperiode oder einer Nachimpulsperiode in einem Verifizierungszyklus (506) einer zweiten Schleife des Programmiervorgangs nach der ersten Schleife, wobei die zweite Schleife einen Programmierzyklus (504) und den Verifizierungszyklus (506) enthält.

2. Speichervorrichtung (100) nach Anspruch 1, wobei der Programmiervorgang ein Incremental Step Pulse Program (ISPP) ist und die erste Schleife und die zweite Schleife jeweils eine Startschleife und eine Endschleife des ISPP sind.

3. Speichervorrichtung (100) nach Anspruch 1 oder 2, wobei der Wortleitungstreiber ferner konfiguriert ist:
zum Abschalten des SSG-Transistors (110) in dem nicht ausgewählten Speicherstring in der Vorimpulsperiode und der Nachimpulsperiode in der ersten Schleife des Programmiervorgangs; und
zum Anschalten des SSG-Transistors (110) in dem nicht ausgewählten Speicherstring in zumindest einer der Vorimpulsperiode oder der Nachimpulsperiode in der zweiten Schleife des Programmiervorgangs.

4. Speichervorrichtung nach Anspruch 3, wobei der Wortleitungstreiber (308) ferner konfiguriert ist:
zum Abschalten des DSG-Transistors (112) und des SSG-Transistors (110) in den nicht ausgewählten Speicherstring in einer Verifizierungsperiode zwischen der Vorimpulsperiode und der Nachimpulsperiode in der ersten Schleife des Programmiervorgangs; und
zum Abschalten des DSG-Transistors (112) und des SSG-Transistors (110) in dem nicht ausgewählten Speicherstring in einer Verifizierungsperiode zwischen der Vorimpulsperiode und der Nachimpulsperiode in der zweiten Schleife des Programmiervorgangs.

5. Speichervorrichtung nach Anspruch 3 oder 4, wobei der Wortleitungstreiber (308) ferner konfiguriert ist:
zum Abschalten des DSG-Transistors (112) und des SSG-Transistors (110) in dem nicht ausgewählten Speicherstring in der Vorimpulsperiode in der zweiten Schleife des Programmiervorgangs; und
zum Anschalten des DSG-Transistors (112) und des SSG-Transistors (110) in dem nicht ausgewählten Speicherstring in der Nachimpulsperiode in der zweiten Schleife des Programmiervorgangs.

6. Speichervorrichtung nach Anspruch 3 oder 4, wobei der Wortleitungstreiber (308) ferner konfiguriert ist:
zum Anschalten des DSG-Transistors (112) und des SSG-Transistors (110) in dem nicht ausgewählten Speicherstring in der Vorimpulsperiode in der zweiten Schleife des Programmiervorgangs; und
zum Abschalten des DSG-Transistors (112) und des SSG-Transistors (110) in dem nicht ausgewählten Speicherstring in der Nachimpulsperiode in der zweiten Schleife des Programmiervorgangs.

7. Speichervorrichtung nach einem der Ansprüche 1 bis 6, wobei der DSG-Transistor (112) in dem ausgewählten Speicherstring elektrisch von dem DSG-Transistor (112) in dem nicht ausgewählten Speicherstring getrennt ist.

8. Verfahren für den Betrieb der Speichervorrichtung nach einem der Ansprüche 1 bis 7, **gekennzeichnet durch**:
Abschalten des DSG-Transistors (112) in einem nicht ausgewählten Speicherstring der Speicherstrings in einer Vorimpulsperiode und einer Nachimpulsperiode in einem Verifizierungszyklus einer ersten Schleife eines Programmiervorgangs, wobei die erste Schleife einen Programmierzyklus (504) und den Verifizierungszyklus (506) enthält; und
Anschalten des DSG-Transistors (112) im nicht ausgewählten Speicherstring in zumindest einer Vorimpulsperiode oder einer Nachimpulsperiode in einem Verifizierungszyklus einer zweiten Schleife des Programmiervorgangs nach der ersten Schleife, wobei die zweite Schleife eine Programmierzyklus (504) und den Verifizierungszyklus (506) enthält.

9. Verfahren nach Anspruch 8, wobei der Programmiervorgang ein Incremental Step Pulse Program (ISPP) ist und die erste Schleife und die zweite Schleife jeweils eine Startschleife und eine Endschleife des ISPP sind.

10. Verfahren nach Anspruch 8 oder 9, ferner umfassend:
Abschalten des SSG-Transistors (110) im nicht ausgewählten Speicherstring in der Vorimpulsperiode und in der Nachimpulsperiode in der ersten Schleife des Programmiervorgangs; und
Anschalten des SSG-Transistors (110) im nicht ausgewählten Speicherstring in zumindest einer der Vorimpulsperiode der der Nachimpulsperiode in der zweiten Schleife des Programmiervorgangs.

11. Verfahren nach Anspruch 10, ferner umfassend:
Abschalten des DSG-Transistors (112) und des SSG-Transistors (110) im nicht ausgewählten Speicherstring in einer Verifizierungsperiode zwischen der Vorimpulsperiode und der Nachimpulsperiode in der ersten Schleife des Programmiervorgangs; und
Abschalten des DSG-Transistors (112) und des SSG-Transistors (110) im nicht ausgewählten Speicherstring in einer Verifizierungsperiode zwischen der Vorimpulsperiode und der Nachimpulsperiode in der zweiten Schleife des Programmiervorgangs.

12. Verfahren nach Anspruch 10 oder 11, ferner umfassend:
Abschalten des DSG-Transistors (112) und des SSG-Transistors (110) im nicht ausgewählten Speicherstring in der Vorimpulsperiode in der zweiten Schleife des Programmiervorgangs; und
Anschalten des DSG-Transistors (112) und des SSG-Transistors (110) im nicht ausgewählten Speicherstring in der Nachimpulsperiode in der zweiten Schleife des Programmiervorgangs.

13. Verfahren nach Anspruch 10 oder 11, ferner umfassend:
Anschalten des DSG-Transistors (112) und des SSG-Transistors (110) im nicht ausgewählten Speicherstring in der Vorimpulsperiode in der zweiten Schleife des Programmiervorgangs; und
Abschalten des DSG-Transistors (112) und des SSG-Transistors (110) im nicht ausgewählten Speicherstring in der Nachimpulsperiode in der zweiten Schleife des Programmiervorgangs.

14. Verfahren nach einem der Ansprüche 8 bis 13, wobei der DSG-Transistor (112) in einem ausgewählten Speicherstring elektrisch von dem DSG-Transistor (112) im nicht ausgewählten Speicherstring getrennt wird.

15. System, umfassend:
eine zum Speicher Daten ausgebildete Speichervorrichtung (100) nach einem der Ansprüche 1 bis 7; und
einen Speicher-Controller (1306), der mit der Speichervorrichtung verbunden ist und zum Steuern der Speichervorrichtung konfiguriert ist.

## Revendications

1. Dispositif de mémoire (100) comprenant:
des chaînes de mémoire (108) comprenant chacune un transistor à grille de sélection de drain (DSG) (112), des cellules de mémoire (106) et un transistor à grille de sélection de source (SSG) (110), le dispositif de mémoire étant un dispositif de mémoire flash NAND; et
un circuit périphérique (102) connecté aux chaînes de mémoire (108) et conçu pour, lors d'une opération de programmation, programmer une cellule de mémoire sélectionnée parmi les cellules de mémoire (106) dans une chaîne de mémoire sélectionnée parmi les chaînes de mémoire (108) et à bloquer une cellule de mémoire non sélectionnée parmi les cellules de mémoire (106) dans une chaîne de mémoire non sélectionnée parmi les chaînes de mémoire (108), le circuit périphérique (102) étant **caractérisé par**:
un pilot de ligne de mots (308) configuré pour:
désactiver le transistor DSG (112) dans la chaîne de mémoire non sélectionnée pendant une période de pré-impulsion et une période de post-impulsion au cours d'un cycle de vérification (506) d'une première boucle de l'opération de programmation, la première boucle comprenant un cycle de programmation (504) et le cycle de vérification (506); et
activer le transistor DSG (112) dans la chaîne de mémoire non sélectionnée au cours d'au moins l'une d'une période de pré-impulsion ou de post-impulsion dans un cycle de vérification (506) d'une deuxième boucle de l'opération de programmation suivant la première boucle, la deuxième boucle comprenant un cycle de programmation (504) et le cycle de vérification (506).

2. Dispositif de mémoire (100) selon la revendication 1, dans lequel le processus de programmation est un programme à impulsions par pas incrémental (ISPP) et la première boucle et la deuxième boucle sont respectivement une boucle de début et une boucle de fin de l'ISPP.

3. Dispositif de mémoire (100) selon la revendication 1 ou 2, dans lequel le pilote de ligne de mots est en outre configuré:
pour désactiver le transistor SSG (110) dans la chaîne de mémoire non sélectionnée pendant la période de pré-impulsion et la période de post-impulsion de la première boucle du processus de programmation; et
pour activer le transistor SSG (110) dans la chaîne de mémoire non sélectionnée pendant au moins l'une de la période pré-impulsion ou de la période post-impulsion de la deuxième boucle de l'opération de programmation.

4. Dispositif de mémoire selon la revendication 3, dans lequel le pilote de ligne de mots (308) est en outre configuré:
pour désactiver le transistor DSG (112) et le transistor SSG (110) dans la chaîne de mémoire non sélectionnée au cours d'une période de vérification entre la période de pré-impulsion et la période de post-impulsion dans la première boucle de l'opération de programmation; et
pour désactiver le transistor DSG (112) et le transistor SSG (110) dans la chaîne de mémoire non sélectionnée au cours d'une période de vérification comprise entre la période de pré-impulsion et la période de post-impulsion dans la deuxième boucle de l'opération de programmation.

5. Dispositif de mémoire selon la revendication 3 ou 4, dans lequel le pilote de ligne de mots (308) est en outre configuré:
pour désactiver le transistor DSG (112) et le transistor SSG (110) dans la chaîne de mémoire non sélectionnée pendant la période de pré-impulsion dans la deuxième boucle de l'opération de programmation; et
pour activer le transistor DSG (112) et le transistor SSG (110) dans la chaîne de mémoire non sélectionnée pendant la période de post-impulsion dans la deuxième boucle de l'opération de programmation.

6. Dispositif de mémoire selon la revendication 3 ou 4, dans lequel le pilote de ligne de mots (308) est en outre configuré:
pour activer le transistor DSG (112) et le transistor SSG (110) dans la chaîne de mémoire non sélectionnée pendant la période de pré-impulsion de la deuxième boucle de l'opération de programmation; et
pour désactiver le transistor DSG (112) et le transistor SSG (110) dans la chaîne de mémoire non sélectionnée pendant la période de post-impulsion dans la deuxième boucle de l'opération de programmation.

7. Dispositif de mémoire selon l'une quelconque des revendications 1 à 6, dans lequel le transistor DSG (112) dans la chaîne de mémoire sélectionnée est isolé électriquement du transistor DSG (112) dans la chaîne de mémoire non sélectionnée.

8. Procédé de fonctionnement du dispositif de mémoire selon l'une des revendications 1 à 7, **caractérisé par**:
la désactivation du transistor DSG (112) dans une chaîne de mémoire non sélectionnée parmi les chaînes de mémoire pendant une période de pré-impulsion et une période de post-impulsion dans un cycle de vérification d'une première boucle d'une opération de programmation, la première boucle comprenant un cycle de programmation (504) et le cycle de vérification (506); et
l'activation du transistor DSG (112) dans la chaîne de mémoire non sélectionnée au cours d'au moins l'une d'une période de pré-impulsion ou d'une période de post-impulsion dans un cycle de vérification d'une deuxième boucle de l'opération de programmation suivant la première boucle, la deuxième boucle comprenant un cycle de programmation (504) et le cycle de vérification (506).

9. Procédé selon la revendication 8, dans lequel l'opération de programmation est un programme par impulsions incrémentales (ISPP) et la première boucle et la deuxième boucle sont respectivement une boucle de départ et une boucle de fin de l'ISPP.

10. Procédé selon la revendication 8 ou 9, comprenant en outre:
la désactivation du transistor SSG (110) dans la chaîne de mémoire non sélectionnée pendant la période de pré-impulsion et la période de post-impulsion dans la première boucle de l'opération de programmation; et
l'activation du transistor SSG (110) dans la chaîne de mémoire non sélectionnée pendant au moins l'une de la période de pré-impulsion et de la période de post-impulsion dans la deuxième boucle de l'opération de programmation.

11. Procédé selon la revendication 10, comprenant en outre:
la désactivation du transistor DSG (112) et du transistor SSG (110) dans la chaîne de mémoire non sélectionnée dans d'une période de vérification entre la période de pré-impulsion et la période de post-impulsion dans la première boucle du processus de programmation; et
la désactivation du transistor DSG (112) et du transistor SSG (110) dans la chaîne de mémoire non sélectionnée dans une période de vérification entre la période de pré-impulsion et la période de post-impulsion dans la deuxième boucle de l'opération de programmation.

12. Procédé selon la revendication 10 ou 11, comprenant en outre:
la désactivation du transistor DSG (112) et du transistor SSG (110) dans la chaîne de mémoire non sélectionnée pendant la période de pré-impulsion dans la deuxième boucle de l'opération de programmation; et
l'activation du transistor DSG (112) et du transistor SSG (110) dans la chaîne de mémoire non sélectionnée pendant la période de post-impulsion dans la deuxième boucle de l'opération de programmation.

13. Procédé selon la revendication 10 ou 11, comprenant en outre:
l'activation du transistor DSG (112) et du transistor SSG (110) dans la chaîne de mémoire non sélectionnée pendant la période de pré-impulsion dans la deuxième de l'opération de programmation; et
la désactivation du transistor DSG (112) et du transistor SSG (110) dans la chaîne de mémoire non sélectionnée pendant la période de post-impulsion de la deuxième boucle de l'opération de programmation.

14. Procédé selon l'une quelconque des revendications 8 à 13, dans lequel le transistor DSG (112) dans une chaîne de mémoire sélectionnée est isolé électriquement du transistor DSG (112) dans la chaîne de mémoire non sélectionnée.

15. Système comprenant:
un dispositif de mémoire (100) conçu pour stocker des données selon l'une quelconque des revendications 1 à 7; et
un contrôleur de mémoire (1306) connecté au dispositif de mémoire et configuré pour commander le dispositif de mémoire.
